(19) Europäisches Patentamt
European Patent Office
Office européen des brevets

(11) EP 3 511 701 A1

(12) # DEMANDE DE BREVET EUROPEEN

(43) Date de publication:
**17.07.2019 Bulletin 2019/29**

(21) Numéro de dépôt: **19158799.7**

(22) Date de dépôt: **19.12.2014**

(51) Int Cl.:
***G01N 21/64*** *(2006.01)* ***G01N 21/95*** *(2006.01)*
*H01L 21/66* *(2006.01)*

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.12.2013 FR 1363105**

(62) Numéro(s) de document de la (des) demande(s) initiale(s) en application de l'article 76 CBE:
**14816242.3 / 3 084 402**

(71) Demandeur: **Commissariat à l'Energie Atomique et aux Energies Alternatives**
**75015 Paris (FR)**

(72) Inventeurs:
- **NOS AGUILA, Oriol**
  **38000 GRENOBLE (FR)**
- **FAVRE, Wilfried**
  **73000 CHAMBERY (FR)**
- **OZANNE, Fabien**
  **38580 ALLEVARD (FR)**
- **RIBEYRON, Pierre-Jean**
  **38330 SAINT ISMIER (FR)**

(74) Mandataire: **Novaimo**
**ActiTech 8**
**60 avenue Marie Curie**
**Archamps Technopole**
**74166 Saint Julien-en-Genevois Cedex (FR)**

Remarques:
Cette demande a été déposée le 22-02-2019 comme demande divisionnaire de la demande mentionnée sous le code INID 62.

(54) **PROCEDE ET SYSTEME DE CONTROLE DE QUALITE DE CELLULES PHOTOVOLTAÏQUES**

(57) Le procédé comprend, pour chaque cellule :
• une étape d'excitation (E3), lors de laquelle la cellule à contrôler ($CLC_k$) est soumise à une excitation avec un niveau d'excitation déterminé ;
• une étape (E4) d'acquisition d'au moins une image ($IM_{PL,k}$) de luminescence de la cellule à contrôler ($CLC_k$) après excitation ;
• une étape (E5) de traitement de l'image acquise ($IM_{PL,k}$);
caractérisé en ce qu'il est prévu, pour chaque cellule ($CLC_k$), une étape préalable (E2) de détermination d'un niveau d'excitation ajusté ($P[CLC_k]$) à ladite cellule ($CLC_k$), les niveaux d'excitation ajustés respectifs des différentes cellules à contrôler étant adaptés de manière à ce que les intensités de luminescence ($I_{PL,k}$) des signaux émis par les différentes cellules soient égales à une même intensité de luminescence de référence ($I_{PL,ref}$).

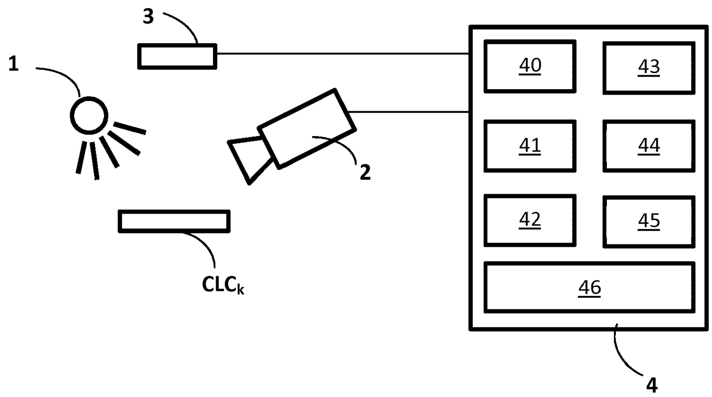


**Figure 1**

EP 3 511 701 A1

**Description**

La présente invention concerne un procédé et un système de contrôle de qualité de cellules photovoltaïques, par exemple par photoluminescence ou par électroluminescence.

Une image de photoluminescence d'une cellule photovoltaïque, acquise suite à une excitation de la cellule par un faisceau d'éclairement, permet de localiser des défauts préjudiciables à la performance de la cellule. Ces défauts apparaissent dans l'image comme des zones plus obscures que le fond de l'image. Différentes méthodes proposent d'utiliser les images de photoluminescence pour déterminer des paramètres de la cellule, notamment pour identifier et/ou quantifier les défauts présents dans la cellule.

Le document « Calculation of quantitative shunt values using photoluminescence imaging », Augarten Y., Trupke T., Lenio M., Bauer J., Weber J.W., Juhl M. Kasemann M., Breitenstein O. (Prog. Photovolt. : Res. Appli., 21 :933-941. Doi :10.1002/pip.2180 (2013)) propose une méthode de quantification de pertes en courant dues à des défauts présents dans une cellule à partir d'images de photoluminescence de la cellule. Le document « Suns-PLI as a powerful tool for spatially resolved fill factor analysis of solar cells » Mchl B., Impera D., Bivour M., Warta W., Schubert M.C. (Prog. Photovolt. : Res. Appl. Doi 10.1002/pip.2293 (2012)) décrit une méthode de détermination d'une carte de tension en circuit ouvert (VOC) et de carte de pseudo-facteur de forme (PFF) d'une cellule de silicium à partir d'intensités de photoluminescence mesurées pour les pixels d'une image de photoluminescence de la cellule. Enfin, le document « Correlations of Cu(In, Ga)Se2 imaging with device performance, defects and microstructural properties » Johnston S. et al. (J. Vac. Sci. Technol. A 30, 04D111 (2012)) étudie la corrélation entre une intensité moyenne de luminescence d'une cellule Cu(InGa)Se2, déterminée à partir d'images de luminescence de la cellule, et, d'une part, une tension en en circuit ouvert de la cellule et, d'autre part, un facteur de forme de la cellule.

Dans les méthodes existantes, les images de photoluminescence des cellules photovoltaïques contrôlées sont obtenues en excitant les cellules par illumination monochromatique (laser) avec une densité de puissance d'éclairement fixée et pendant une durée prédéfinie. Les résultats obtenus ne sont toutefois pas totalement satisfaisants car, selon la cellule analysée, les défauts de celle-ci sont plus ou moins détectables dans les images de photoluminescence.

La présente invention vient améliorer la situation.

A cet effet, l'invention concerne un procédé de contrôle de qualité d'une pluralité de cellules photovoltaïques comprenant, pour chaque cellule :

- une étape d'excitation, lors de laquelle la cellule à contrôler est soumise à une excitation avec un niveau d'excitation déterminé ;
- une étape d'acquisition d'au moins une image de luminescence de la cellule à contrôler après excitation ;
- une étape de traitement de l'image acquise ;

caractérisé en ce qu'il est prévu, pour chaque cellule, une étape préalable de détermination d'un niveau d'excitation ajusté à ladite cellule, les niveaux d'excitation ajustés respectifs des différentes cellules à contrôler étant adaptés de manière à ce que les intensités de luminescence des signaux émis par les différentes cellules soient égales à une même intensité de luminescence de référence.

L'invention consiste donc à adapter les niveaux d'excitation appliqués aux différentes cellules photovoltaïques à contrôler afin de mettre toutes les cellules au même niveau, sur le plan de leur réponse de luminescence. Grâce à cela, on limite fortement le risque de sous-estimation ou de surestimation des défauts d'une cellule à l'autre. Le traitement des images de luminescence obtenues après excitation des cellules à contrôler à des niveaux d'excitation ajustés, permet de réaliser un contrôle de qualité qui est cohérent entre les différentes cellules, fiable et précis.

Dans un mode de réalisation particulier, lors de l'étape préalable de détermination du niveau d'excitation ajusté à la cellule :

- on mesure l'intensité de luminescence émise par la cellule en réponse à un niveau d'excitation initial choisi ;
- on détermine le niveau d'excitation ajusté à la cellule à partir de l'intensité de luminescence mesurée, de l'intensité de luminescence de référence et de données d'évolution d'une réponse de luminescence d'une cellule en fonction du niveau d'excitation appliqué à ladite cellule.

La cellule à contrôler est initialement excitée avec un niveau d'excitation initial choisi. L'intensité de luminescence du signal de photons émis par une cellule en réponse à cette excitation initiale est mesurée afin de calculer un rapport entre l'intensité mesurée et l'intensité de référence. A partir de ce rapport et compte tenu du niveau initial d'excitation appliqué et de l'évolution connue de l'intensité de luminescence d'une cellule en fonction du niveau d'excitation, on détermine le niveau d'excitation ajusté à appliquer à la cellule pour que sa réponse de luminescence soit égale à l'intensité de référence.

Avantageusement, on calcule un rapport d'intensités entre l'intensité de luminescence de référence et l'intensité de luminescence mesurée, et, les données d'évolution de la réponse de luminescence en fonction du niveau d'excitation appliqué étant normalisées pour le niveau d'excitation initial choisi, on obtient directement le niveau d'excitation ajusté à la cellule à l'aide desdites données d'évolution, à partir dudit rapport d'intensités pris en tant qu'intensité de luminescence.

Grâce à cela, on détermine le niveau d'excitation ajusté de façon simple et rapide, sans calcul supplémentaire.

Avantageusement encore, les cellules à contrôler étant fabriquées par une ligne de fabrication, il est prévu une phase d'apprentissage, lors de laquelle :

- on mesure les tensions en circuit ouvert d'une pluralité de cellules d'apprentissage fabriquées sur ladite ligne de fabrication ;
- on détermine une tension en circuit ouvert de référence, contenue dans une plage définie par une moyenne des tensions en circuit ouvert mesurées plus ou moins de deux fois l'écart type de distribution des tensions en circuit ouvert mesurées;

on détermine l'intensité de luminescence de référence à partir de la tension en circuit ouvert de référence déterminée et pour le niveau d'excitation initial choisi.

Grâce à cela, l'intensité de luminescence de référence est adaptée à la ligne de production des cellules à contrôler.

Dans un mode de réalisation particulier, lors de la phase d'apprentissage

- on soumet les cellules d'apprentissage au niveau d'excitation initial choisi et on mesure les intensités de luminescence des cellules d'apprentissage en réponse à l'excitation ;
- on détermine des données d'évolution de l'intensité de luminescence des cellules d'apprentissage soumises au niveau d'excitation initial choisi, en fonction de la tension en circuit ouvert desdites cellules d'apprentissage.

Par apprentissage, on peut ainsi déterminer des données de variation de l'intensité de luminescence des cellules en fonction de la tension en circuit ouvert de celles-ci et sélectionner une intensité de luminescence de référence à partir de ces données.

Avantageusement, pour chaque cellule à contrôler, l'image de luminescence de ladite cellule étant composée d'un ensemble de pixels auxquels des valeurs respectives d'intensité de luminescence sont attribuées, lors de l'étape de traitement :

- on décompose l'image de luminescence de la cellule à contrôler en une première image correspondant à ladite cellule sans défauts et une deuxième image correspondant à des défauts de ladite cellule
- on calcule une moyenne des valeurs d'intensité de luminescence associées aux pixels de la deuxième image afin de déterminer un paramètre de quantification des défauts de la cellule

Suite à l'excitation ajustée de la cellule à contrôler, une image de la réponse de luminescence de la cellule est acquise puis décomposée en deux images secondaires correspondant respectivement au fond de l'image et aux défauts de la cellule. A partir de l'image secondaire contenant les défauts de la cellule, on peut réaliser une moyenne des intensités de luminescence des pixels et déterminer ainsi un paramètre de quantification des défauts.

Avantageusement encore, le paramètre de quantification des défauts est corrigé par un facteur de correction déterminé à partir d'une moyenne de valeurs des pixels de la première image.

Du fait de l'ajustement des niveaux d'excitation appliqués aux cellules à contrôler, les fonds d'image devraient idéalement être tous identiques. Toutefois, du fait d'erreurs de réglage notamment, de légères déviations sont possibles. Il en résulte une sous-estimation ou une surestimation des défauts. Pour corriger cela, le paramètre de quantification des défauts est pondéré par un facteur de correction déterminé à partir de la valeur moyenne d'intensité de luminescence de l'image du fond.

Dans un mode de réalisation particulier, lors d'une phase d'apprentissage, on détermine des données de corrélation entre un paramètre de perte de facteur de forme et le paramètre de quantification des défauts, pour des cellules d'apprentissage.

Dans ce cas, avantageusement, pour chaque cellule à contrôler, on évalue un paramètre de perte de facteur de forme de ladite cellule à partir du paramètre de quantification des défauts déterminé et desdites données de corrélation.

A partir du paramètre de quantification des défauts d'une cellule à contrôler, on peut ainsi estimer l'impact des défauts sur le facteur de forme. Plus précisément, à l'aide de données corrélation entre le paramètre de quantification de défauts et une perte de facteur de forme, obtenues par apprentissage, et à partir du paramètre de quantification des défauts déterminé de la cellule à contrôler, on peut évaluer une perte sur le facteur de forme de la cellule induite par les défauts.

Avantageusement encore, il est mis en oeuvre, pour chaque cellule à contrôler, avant ou après une étape de métallisation de ladite cellule, en cours de fabrication.

Grâce à cela, on peut stopper la fabrication des cellules défectueuses, notamment avant métallisation et économiser ainsi du métal.

Le mode d'excitation de la cellule à contrôler peut être un faisceau lumineux ou un courant électrique.

L'invention concerne aussi un système de contrôle de qualité d'une pluralité de cellules photovoltaïques comprenant des moyens matériels et logiciels pour mettre en oeuvre les étapes du procédé qui vient d'être défini.

Dans une forme de réalisation particulière, le système comprend:

- un dispositif d'excitation adapté pour appliquer à une cellule à contrôler une excitation avec un niveau d'excitation déterminé ;
- un dispositif d'acquisition d'une image de luminescence de la cellule après excitation ;
- un module de traitement d'image ;

et est caractérisé en ce qu'il comprend un module de détermination de niveaux d'excitation ajustés à des cellules à contrôler, adapté pour ajuster les niveaux d'excitation respectifs des cellules à contrôler de manière à ce que les intensités de luminescence émises par lesdites cellules soit égales à une même intensité de luminescence de référence

Le système peut comprendre tout ou partie des caractéristiques additionnelles suivantes :

- le module de détermination de niveaux d'excitation ajustés aux cellules à contrôler est agencé pour déterminer le niveau d'excitation ajusté pour une cellule à contrôler à partir d'une intensité de luminescence mesurée de ladite cellule en réponse à un niveau d'excitation initial choisi, de l'intensité de luminescence de référence et de données d'évolution d'une réponse de luminescence d'une cellule en fonction du niveau d'excitation appliqué à ladite cellule ;
- il comprend un module d'apprentissage adapté pour déterminer
  - une tension en circuit ouvert de référence, à partir de tensions en circuit ouvert mesurées de cellules d'apprentissage, ladite tension en circuit ouvert de référence étant contenue dans une plage définie par une moyenne des tensions en circuit ouvert mesurées plus ou moins de deux fois l'écart type de distribution des tensions en circuit ouvert mesurées, et
  - l'intensité de luminescence de référence à partir de la tension en circuit ouvert de référence déterminée et pour le niveau d'excitation initial choisi ;
- le module de traitement d'image est adapté pour décomposer l'image de luminescence d'une cellule à contrôler, acquise après excitation de ladite cellule au niveau d'excitation ajusté, en une première image correspondant à ladite cellule sans défauts et une deuxième image correspondant à des défauts de ladite cellule, et en ce qu'il comprend un module de détermination d'un paramètre de quantification de défauts de la cellule à contrôler agencé pour calculer une moyenne des valeurs d'intensité de luminescence associées aux pixels de la deuxième image ;
- il comprend un module d'évaluation d'un paramètre de perte de facteur de forme d'une cellule à contrôler à partir du paramètre déterminé de quantification des défauts de ladite cellule et de données de corrélation entre le paramètre de perte de facteur de forme et le paramètre de quantification des défauts.

L'invention concerne aussi un procédé de contrôle de qualité d'une pluralité de cellules photovoltaïques comprenant, pour chaque cellule :

- une étape d'excitation, lors de laquelle la cellule à contrôler est soumise à une excitation ;
- une étape d'acquisition d'au moins une image de luminescence de la cellule à contrôler après excitation ;
- une étape de traitement de l'image acquise;

caractérisé en ce, pour chaque cellule à contrôler, lors de l'étape de traitement, on décompose l'image de luminescence de la cellule à contrôler en une première image correspondant à ladite cellule sans défauts et une deuxième image correspondant à des défauts de ladite cellule.

Avantageusement, pour décomposer l'image de luminescence de la cellule à contrôler, l'image de luminescence de ladite cellule étant composée d'un ensemble de pixels auxquels des valeurs respectives d'intensité de luminescence sont attribuées :

- on choisit une pluralité de pixels de ladite image de luminescence :
- on attribue à chacun des pixels choisis une valeur qui est représentative d'un environnement local dudit pixel ;
- on attribue une nouvelle valeur à chaque pixel de l'image à partir des valeurs des pixels choisis afin d'obtenir une première image correspondant à la cellule sans défauts ;

- on détermine une deuxième image correspondant à des défauts de ladite cellule à partir de l'image de luminescence et de la première image.

Avantageusement encore, on calcule une moyenne des valeurs d'intensité de luminescence associées aux pixels de la deuxième image afin de déterminer un paramètre de quantification des défauts de la cellule.

Le procédé comprend avantageusement tout ou partie des caractéristiques additionnelles suivantes :

- on obtient ladite deuxième image en réalisant un ratio ou une soustraction entre l'image de luminescence de la cellule et la première image ;
- on attribue une nouvelle valeur à chaque pixel de l'image par interpolation des valeurs des pixels choisis ;
- le paramètre de quantification des défauts est corrigé par un facteur de correction déterminé à partir d'une moyenne de valeurs des pixels de la première image ;
- les pixels choisis de l'image de luminescence sont situés à des emplacements périodiquement espacés.

L'invention concerne enfin un système de contrôle de qualité d'une pluralité de cellules photovoltaïques, comprenant :

- un dispositif d'excitation adapté pour appliquer une excitation à une cellule à contrôler ;
- un dispositif d'acquisition d'une image de luminescence de la cellule après excitation ;
- un module de traitement d'image ;

caractérisé en ce que le module de traitement d'image est adapté pour décomposer l'image de luminescence de chaque cellule à contrôler en une première image correspondant à ladite cellule sans défauts et une deuxième image correspondant à des défauts de ladite cellule.

Le module de traitement d'image est avantageusement agencé pour choisir une pluralité de pixels de ladite image de luminescence, attribuer à chacun des pixels choisis une valeur qui est représentative d'un environnement local dudit pixel, attribuer une nouvelle valeur à chaque pixel de l'image à partir des valeurs des pixels choisis afin d'obtenir la première image, déterminer la deuxième image à partir de l'image de luminescence et de la première image.

Le module de traitement d'image est avantageusement encore adapté pour calculer une moyenne des valeurs d'intensité de luminescence associées aux pixels de la deuxième image afin de déterminer un paramètre de quantification des défauts de la cellule.

Ainsi, selon un premier aspect de l'invention, un procédé est défini par les propositions suivantes :

1. Procédé de contrôle de qualité d'une pluralité de cellules photovoltaïques ($CLC_k$) comprenant, pour chaque cellule :

   - une étape d'excitation (E3), lors de laquelle la cellule à contrôler ($CLC_k$) est soumise à une excitation ;
   - une étape (E4) d'acquisition d'au moins une image ($IM_{PL,k}$) de luminescence de la cellule à contrôler ($CLC_k$) après excitation ;
   - une étape (E5) de traitement de l'image acquise ($IM_{PL,k}$) ;

   caractérisé en ce, pour chaque cellule à contrôler, lors de l'étape de traitement, on décompose (E50) l'image de luminescence de la cellule à contrôler ($CLC_k$) en une première image correspondant à ladite cellule sans défauts et une deuxième image correspondant à des défauts de ladite cellule.

2. Procédé selon la proposition 1, caractérisé en ce que, pour décomposer l'image de luminescence de la cellule à contrôler ($CLC_k$), l'image de luminescence de ladite cellule étant composée d'un ensemble de pixels auxquels des valeurs respectives d'intensité de luminescence sont attribuées :

   - on choisit une pluralité (N) de pixels de ladite image de luminescence :
   - on attribue à chacun des pixels choisis une valeur qui est représentative d'un environnement local dudit pixel ;
   - on attribue une nouvelle valeur à chaque pixel de l'image à partir des valeurs des pixels choisis afin d'obtenir une première image correspondant à la cellule sans défauts ;
   - on détermine une deuxième image correspondant à des défauts de ladite cellule à partir de l'image de luminescence et de la première image.

3. Procédé selon la proposition 2, caractérisé en ce qu'on calcule (E51) une moyenne des valeurs d'intensité de luminescence associées aux pixels de la deuxième image afin de déterminer un paramètre de quantification des défauts de la cellule.

4. Procédé selon l'une des propositions 1 à 3, caractérisé en ce qu'on obtient ladite deuxième image en réalisant un ratio ou une soustraction entre l'image de luminescence de la cellule et la première image.
5. Procédé selon l'une des propositions 1 à 4, caractérisé en ce qu'on attribue une nouvelle valeur à chaque pixel de l'image par interpolation des valeurs des pixels choisis.
6. Procédé selon l'une des propositions 3 à 5, caractérisé en ce que le paramètre de quantification des défauts est corrigé (E53) par un facteur de correction déterminé à partir d'une moyenne de valeurs des pixels de la première image.
7. Procédé selon l'une des propositions 1 à 6, caractérisé en ce que les pixels choisis de l'image de luminescence sont situés à des emplacements périodiquement espacés.
Selon un deuxième aspect de l'invention, un procédé est défini par les propositions suivantes :
8. Procédé de contrôle de qualité d'une pluralité de cellules photovoltaïques ($CLC_k$) comprenant, pour chaque cellule :

- une étape d'excitation (E3), lors de laquelle la cellule à contrôler ($CLC_k$) est soumise à une excitation avec un niveau d'excitation déterminé ;
- une étape (E4) d'acquisition d'au moins une image ($IM_{PL,k}$) de luminescence de la cellule à contrôler ($CLC_k$) après excitation ;
- une étape (E5) de traitement de l'image acquise ($IM_{PL,k}$) ;
caractérisé en ce qu'il est prévu, pour chaque cellule ($CLC_k$), une étape préalable (E2) de détermination d'un niveau d'excitation ajusté ($P[CLC_k]$) à ladite cellule ($CLC_k$), les niveaux d'excitation ajustés respectifs des différentes cellules à contrôler étant adaptés de manière à ce que les intensités de luminescence ($I_{PL,k}$) des signaux émis par les différentes cellules soient égales à une même intensité de luminescence de référence ($I_{PL,ref}$).

9. Procédé selon la proposition 8, caractérisé en ce que, lors de l'étape préalable (E2) de détermination du niveau d'excitation ajusté à la cellule :

- on mesure (E20) l'intensité de luminescence ($I_{PL,k}[P_{init}]$) émise par la cellule en réponse à un niveau d'excitation initial choisi ($P_{init}$) ;
- on détermine (E23) le niveau d'excitation ajusté $P[CLC_k]$ à la cellule ($CLC_k$) à partir de l'intensité de luminescence mesurée, de l'intensité de luminescence de référence ($I_{PL,ref}$) et de données ($C_2$) d'évolution d'une réponse de luminescence d'une cellule en fonction du niveau d'excitation appliqué à ladite cellule.

10. Procédé selon la proposition 9, caractérisé en ce qu'on calcule (E22) un rapport d'intensités entre l'intensité de luminescence de référence et l'intensité de luminescence mesurée, et, les données d'évolution de la réponse de luminescence en fonction du niveau d'excitation appliqué étant normalisées pour le niveau d'excitation initial choisi, on obtient directement le niveau d'excitation ajusté à la cellule à l'aide desdites données d'évolution, à partir dudit rapport d'intensités pris en tant qu'intensité de luminescence.
11. Procédé selon l'une des propositions 8 à 10, caractérisé en ce que, les cellules à contrôler étant fabriquées par une ligne de fabrication, il est prévu une phase d'apprentissage, lors de laquelle :

- on mesure (E01) les tensions en circuit ouvert d'une pluralité de cellules d'apprentissage fabriquées sur ladite ligne de fabrication ;
- on détermine (E02) une tension en circuit ouvert de référence, contenue dans une plage définie par une moyenne des tensions en circuit ouvert mesurées plus ou moins de deux fois l'écart type de distribution des tensions en circuit ouvert mesurées;
- on détermine (E07) l'intensité de luminescence de référence à partir de la tension en circuit ouvert de référence déterminée et pour le niveau d'excitation initial choisi.

12. Procédé selon la proposition 11, caractérisé en ce que, lors de la phase d'apprentissage,

- on soumet (E03) les cellules d'apprentissage au niveau d'excitation initial choisi et on mesure (E04) les intensités de luminescence des cellules d'apprentissage en réponse à l'excitation ;
- on détermine (E06) des données d'évolution de l'intensité de luminescence des cellules d'apprentissage soumises au niveau d'excitation initial choisi, en fonction de la tension en circuit ouvert desdites cellules d'apprentissage.

13. Procédé selon l'une des propositions 8 à 12, caractérisé en ce que, pour chaque cellule à contrôler, l'image de luminescence de ladite cellule étant composée d'un ensemble de pixels auxquels des valeurs respectives d'intensité de luminescence sont attribuées, lors de l'étape de traitement :

- on décompose (E50) l'image de luminescence de la cellule à contrôler en une première image correspondant à ladite cellule sans défauts et une deuxième image correspondant à des défauts de ladite cellule,
- on calcule (E51) une moyenne des valeurs d'intensité de luminescence associées aux pixels de la deuxième image afin de déterminer un paramètre de quantification des défauts de la cellule.

14. Procédé selon la proposition 13, caractérisé en ce que pour décomposer l'image de luminescence de la cellule à contrôler :

- on choisit une pluralité (N) de pixels de ladite image de luminescence ;
- on attribue à chacun des pixels choisis une valeur qui est représentative d'un environnement local dudit pixel ;
- on attribue une nouvelle valeur à chaque pixel de l'image à partir des valeurs des pixels choisis afin d'obtenir la première image ;
- on détermine la deuxième image à partir de l'image de luminescence et de la première image.

15. Procédé selon la proposition 13 ou 14, caractérisé en ce que le paramètre de quantification des défauts est corrigé (E53) par un facteur de correction déterminé à partir d'une moyenne de valeurs des pixels de la première image.
16. Procédé selon l'une des propositions 13 à 15, caractérisé en ce que, lors d'une phase d'apprentissage, on détermine (E012) des données de corrélation entre un paramètre de perte de facteur de forme et le paramètre de quantification des défauts, pour des cellules d'apprentissage.
17. Procédé selon la proposition 16, caractérisé en ce que, pour chaque cellule à contrôler, on évalue (E0120) un paramètre de perte de facteur de forme de ladite cellule à partir du paramètre de quantification des défauts déterminé et desdites données de corrélation.
18. Procédé selon l'une des propositions 8 à 17, caractérisé en ce qu'il est mis en oeuvre, pour chaque cellule à contrôler, avant ou après une étape de métallisation de ladite cellule, en cours de fabrication.
19. Procédé selon l'une des propositions 8 à 18, caractérisé en ce que, lors de l'étape d'excitation, on soumet la cellule à un éclairement d'excitation.
20. Procédé selon l'une des propositions 8 à 19, caractérisé en ce que, lors de l'étape d'excitation, on soumet la cellule à un courant d'excitation.
Un système est défini par les propositions qui suivent.
21. Système de contrôle de qualité d'une pluralité de cellules photovoltaïques comprenant des moyens matériels et logiciels pour mettre en oeuvre les étapes du procédé selon l'une des propositions 1 à 20.
Selon le premier aspect de l'invention, le système est défini par les propositions suivantes :
22. Système de contrôle de qualité d'une pluralité de cellules photovoltaïques, comprenant :

- un dispositif d'excitation (1) adapté pour appliquer une excitation à une cellule à contrôler ;
- un dispositif (2) d'acquisition d'une image de luminescence de la cellule après excitation ;
- un module de traitement d'image (42) ;

caractérisé en ce que le module (42) de traitement d'image est adapté pour décomposer (E50) l'image de luminescence de chaque cellule à contrôler ($CLC_k$) en une première image correspondant à ladite cellule sans défauts et une deuxième image correspondant à des défauts de ladite cellule.
23. Système selon la proposition 22, caractérisé en ce que, le module de traitement d'image (42) est agencé pour choisir une pluralité (N) de pixels de ladite image de luminescence, attribuer à chacun des pixels choisis une valeur qui est représentative d'un environnement local dudit pixel, attribuer une nouvelle valeur à chaque pixel de l'image à partir des valeurs des pixels choisis afin d'obtenir la première image, déterminer la deuxième image à partir de l'image de luminescence et de la première image.
24. Système selon la proposition 23, caractérisé en ce que le module (42) de traitement d'image est adapté pour calculer (E51) une moyenne des valeurs d'intensité de luminescence associées aux pixels de la deuxième image afin de déterminer un paramètre de quantification des défauts de la cellule.
Selon le deuxième aspect de l'invention, le système est défini par les propositions suivantes :
25. Système de contrôle de qualité d'une pluralité de cellules photovoltaïques, comprenant :

- un dispositif d'excitation (1) adapté pour appliquer à une cellule à contrôler une excitation avec un niveau d'excitation déterminé ;
- un dispositif (2) d'acquisition d'une image de luminescence de la cellule après excitation ;

- un module de traitement d'image (42) ;

caractérisé en ce qu'il comprend un module (41) de détermination de niveaux d'excitation ajustés à des cellules à contrôler, adapté pour ajuster les niveaux d'excitation respectifs des cellules à contrôler de manière à ce que les intensités de luminescence émises par lesdites cellules soit égales à une même intensité de luminescence de référence.

26. Système selon la proposition 25, caractérisé en ce que le module (41) de détermination de niveaux d'excitation ajustés aux cellules à contrôler est agencé pour déterminer le niveau d'excitation ajusté pour une cellule à contrôler à partir d'une intensité de luminescence mesurée de ladite cellule en réponse à un niveau d'excitation initial choisi, de l'intensité de luminescence de référence et de données d'évolution d'une réponse de luminescence d'une cellule en fonction du niveau d'excitation appliqué à ladite cellule.

27. Système selon l'une des propositions 25 et 26, caractérisé en ce qu'il comprend un module d'apprentissage (40) adapté pour déterminer

- une tension en circuit ouvert de référence, à partir de tensions en circuit ouvert mesurées de cellules d'apprentissage, ladite tension en circuit ouvert de référence étant contenue dans une plage définie par une moyenne des tensions en circuit ouvert mesurées plus ou moins de deux fois l'écart type de distribution des tensions en circuit ouvert mesurées, et
- l'intensité de luminescence de référence à partir de la tension en circuit ouvert de référence déterminée et pour le niveau d'excitation initial choisi.

28. Système selon l'une des propositions 25 à 27, caractérisé en ce que le module de traitement d'image (42) est adapté pour décomposer l'image de luminescence d'une cellule à contrôler, acquise après excitation de ladite cellule au niveau d'excitation ajusté, en une première image correspondant à ladite cellule sans défauts et une deuxième image correspondant à des défauts de ladite cellule, et en ce qu'il comprend un module de détermination d'un paramètre de quantification de défauts de la cellule à contrôler agencé pour calculer une moyenne des valeurs d'intensité de luminescence associées aux pixels de la deuxième image.

29. Système selon la proposition 28, caractérisé en ce que le module de traitement d'image (42) est adapté pour choisir une pluralité (N) de pixels de ladite image de luminescence, attribuer à chacun des pixels choisis une valeur qui est représentative d'un environnement local dudit pixel, attribuer une nouvelle valeur à chaque pixel de l'image à partir des valeurs des pixels choisis afin d'obtenir la première image, et déterminer la deuxième image à partir de l'image de luminescence et de la première image.

30. Système selon l'une des propositions 25 à 29, caractérisé en ce qu'il comprend un module (43) d'évaluation d'un paramètre de perte de facteur de forme d'une cellule à contrôler à partir du paramètre déterminé de quantification des défauts de ladite cellule et de données de corrélation entre le paramètre de perte de facteur de forme et le paramètre de quantification des défauts.

L'invention sera mieux comprise à l'aide de la description suivante d'un mode de réalisation particulier du procédé et du système de contrôle de qualité d'une pluralité de cellules photovoltaïques de l'invention, en référence aux dessins annexés sur lesquels :

- la figure 1 représente le système de contrôle de qualité, selon une forme de réalisation particulière de l'invention ;
- la figure 2 représente des données d'évolution de la réponse de luminescence d'une cellule photovoltaïque en fonction d'un niveau d'excitation appliqué, l'intensité étant normalisée pour un niveau d'excitation choisi ;
- la figure 3 représente des données d'évolution de l'intensité de luminescence de cellules photovoltaïques d'apprentissage en fonction des tensions en circuit ouvert de ces cellules ;
- la figure 4A représente une image de luminescence relative à une cellule photovoltaïque à contrôler ;
- les figures 4B et 4C représentent deux images obtenues par décomposition de l'image de la figure 4A ;
- les figures 5A et 5B représentent des étapes d'une phase d'apprentissage du procédé, selon un mode de réalisation particulier ;
- les figures 6A et 6B représentent des étapes d'une phase de contrôle de qualité du procédé de l'invention, selon un mode de réalisation particulier ;
- la figure 7 représente les caractéristiques courant-tension et puissance-tension d'une cellule photovoltaïque ;
- la figure 8 représente des données de corrélation entre une paramètre de perte de facteur de forme et un paramètre de quantification des défauts d'une cellule.

Le procédé de contrôle de qualité de l'invention permet de contrôler la qualité de cellules photovoltaïques fabriquées sur une ligne de production L, afin le cas échéant de détecter une ou plusieurs cellules ayant des performances insuffisantes par rapport aux performances souhaitées.

Le contrôle de qualité est mis en oeuvre par un système comportant :

- un dispositif d'excitation 1, destiné à exciter une cellule photovoltaïque de façon à ce qu'elle émette des photons par luminescence,
- un dispositif 2 d'acquisition d'images de luminescence, tel qu'une caméra, destiné à acquérir des images numériques représentatives des photons émis par une cellule photovoltaïque en réponse à une excitation, autrement dit des images de la réponse de luminescence de la cellule suite à une excitation,
- un capteur 3 de mesure d'intensité de luminescence, adapté pour mesurer l'intensité de luminescence d'un signal de photons émis par une cellule photovoltaïque après excitation,
- un dispositif de contrôle 4.

Le système de contrôle de qualité comprend des moyens matériels et logiciels pour mettre en oeuvre les étapes du procédé décrit plus loin.

Le dispositif de contrôle 4 comprend notamment une unité centrale (non représentée), en l'espèce un microprocesseur, et différents modules logiciels :

- un module d'apprentissage 40, apte à commander l'exécution des étapes d'une phase d'apprentissage,
- un module 41 de détermination d'un niveau d'excitation ajusté pour une cellule photovoltaïque,
- un module 42 de traitement d'image et de détermination d'un paramètre de quantification de défauts d'une cellule photovoltaïque,
- un module 43 d'évaluation d'un paramètre de perte de facteur de forme,
- un module 44 de sélection de cellule.

Le dispositif de contrôle 4 comprend en outre une mémoire de stockage 45, pour mémoriser notamment des données obtenues lors de la phase d'apprentissage, et une interface homme-machine 46 (écran, clavier, etc.).

Dans l'exemple de réalisation décrit ici, le mode d'excitation des cellules photovoltaïques est un faisceau lumineux laser. Le dispositif d'excitation 1 est une source d'émission laser. En variante, on pourrait utiliser un autre type de faisceau lumineux ou une excitation par courant électrique.

Les cellules photovoltaïques sont par exemple des cellules silicium à hétérojonction, ou cellules solaires SHJ (de l'anglais « Silicon HeteroJunction »). On pourrait toutefois envisager d'appliquer l'invention à tout autre type de cellules photovoltaïques. On pourra citer par exemple les cellules silicium homojonction, les cellules couches minces à base de silicium amorphe ou d'autres semiconducteurs tels que les cellules CdTe (Tellure de Cadmium), le CuInGaSe (Cuivre-Indium-Sélénite de Gallium) ou le GaAs (Arsénite de Gallium) ou encore les cellules multijonctions.

Le procédé comprend une phase initiale d'apprentissage de la ligne de production L, décrite ci-après.

<u>Phase d'apprentissage</u> :

La phase d'apprentissage permet de déterminer différents paramètres relatifs aux cellules photovoltaïques produites par la ligne de production L, à savoir :

- des données d'évolution de l'intensité de luminescence de cellules photovoltaïques produites par la ligne de production L en fonction d'une tension en circuit ouvert (courbe $C_1$) ;
- une valeur de référence, ou cible, d'intensité de luminescence, notée $I_{PL,ref}$, pour des cellules photovoltaïques à contrôler ;
- des données d'évolution de la réponse de luminescence d'une cellule photovoltaïque en fonction du niveau d'excitation appliqué à celle-ci (courbe $C_2$) ;
- des données de corrélation entre un paramètre GL de quantification de défauts d'une cellule photovoltaïque et un paramètre de perte de facteur de forme de cette cellule ;
- un seuil $TSH_{GL}$ de paramètre de quantification de défauts.

La phase d'apprentissage comprend une première étape E00 de fabrication d'un lot de N cellules photovoltaïques dites « d'apprentissage », notées $CLA_1$, $CLA_2$, ..., $CLA_i$, ..., $CLA_N$, par la ligne de production L. Par exemple, le nombre N peut être de l'ordre de quelques centaines voire de quelques milliers de cellules, suivant le degré de précision que l'on cherche (échantillon représentatif).

Les étapes E01 à E06 permettent de déterminer la courbe $C_1$ et l'intensité de luminescence de référence $I_{PL,ref}$.

De façon connue, une cellule photovoltaïque est caractérisée par une tension en circuit ouvert « $V_{oc}$ », correspondant à la tension aux bornes de la cellule quand aucun courant I n'est débité (I=0). Une ligne de production produit généralement des cellules dont les tensions $V_{oc}$ respectives peuvent varier légèrement d'une cellule à l'autre. Typiquement, les tensions $V_{oc}$ d'un lot de cellules photovoltaïques produites par une ligne de production sont réparties selon une distribution gaussienne autour d'une valeur moyenne $\overline{V_{oc}}$ et avec un écart type $\sigma$ donné.

Lors de l'étape E01, on mesure la tension en circuit ouvert $V_{oc_i}$ de chacune des cellules d'apprentissage $CLA_i$, de façon connue.

Lors de l'étape E02, on calcule une valeur moyenne $\overline{V_{oc}}$ de tension en circuit ouvert, à partir des tensions $V_{oc_i}$ mesurées pour les cellules $CLA_1$ à $CLA_N$.

On mesure ensuite les réponses de photoluminescence de chacune des cellules d'apprentissage $CLA_1$ à $CLA_N$, lorsque celles-ci sont soumises à un faisceau laser d'excitation, avec un niveau d'éclairement choisi, à l'aide du dispositif d'émission laser 1. Dans l'exemple décrit ici, on choisit un niveau d'éclairement égal à 40% de la puissance maximale d'émission laser du dispositif d'émission laser 1, la densité de puissance maximale du laser étant de l'ordre de 120 $mW/cm^2$, et une durée d'émission du faisceau laser de l'ordre de 10 ms. On pourrait choisir un niveau d'éclairement différent, en toute hypothèse adapté de manière à ce que les réponses de photoluminescence des cellules photovoltaïques ne saturent pas le dispositif d'acquisition 2. Notons $P_{init}$ ce niveau d'éclairement initial choisi. En variante, pour obtenir le niveau d'éclairement souhaité, on pourrait choisir une densité de puissance laser fixe (par exemple 40% de la puissance maximale) et régler le niveau d'éclairement en variant la durée du temps d'excitation de la cellule, c'est-à-dire, la durée d'émission du faisceau laser.

Pour mesurer les réponses de photoluminescence des cellules au niveau d'éclairement initial choisi $P_{init}$, lors de l'étape E03, on soumet chaque cellule d'apprentissage $CLA_i$, avec l'indice i étant initialement égal à 1, à un faisceau laser, le dispositif laser 1 étant réglé à une puissance choisie de 40% de sa puissance maximale d'émission.

Lors de l'étape E04, on mesure l'intensité de photoluminescence $I_{PL_i}$ du signal émis par la cellule d'apprentissage $CLA_i$ en réponse à l'excitation laser appliquée lors de l'étape E03.

Pour un niveau d'éclairement donné, il est connu que l'intensité de photoluminescence $I_{PL}$ d'une cellule photovoltaïque dépend de la tension en circuit ouvert $V_{oc}$ de cette cellule. Plus précisément, l'intensité $I_{PL}$ est proportionnelle à $\left(\frac{eV_{oc}}{kT}\right)$. Autrement dit, on a la relation suivante :

$$I_{PL} \propto exp\left(\frac{eV_{oc}}{kT}\right) \qquad (1)$$

où :

- e représente la charge élémentaire ;
- k représente la constante de Boltzmann et
- T représente la température.

Les étapes E03 et E04 sont réitérées pour chacune des cellules d'apprentissage $CLA_i$, l'indice i allant de 1 à N. Une étape de test E05 est prévue pour que le procédé revienne à l'étape E03 tant que l'indice i est inférieur à N (branche N sur la figure 4). Lorsque les réponses de photoluminescence de toutes les cellules CLAi, avec i allant de 1 à N, ont été mesurées, le procédé passe à l'étape E06 (branche Y sur la figure 5A).

A l'issue de l'étape E05, on dispose, pour chaque cellule d'apprentissage $CLA_i$ (avec i compris entre 1 et N), d'un couple de valeurs mesurées ($V_{oc_i}$,$I_{PL_i}$) contenant chacun la tension en circuit ouvert mesurée $V_{oc_i}$ et l'intensité de photoluminescence $I_{PL_i}$ de la cellule $CLA_i$, mesurée en réponse à un éclairement choisi égal à 40% de la puissance maximale d'émission laser du dispositif 1.

Lors de l'étape E06, à partir des couples ($V_{oc_i}$, $I_{PL_i}$) et compte tenu de la relation de proportionnalité (1) connue, le dispositif de contrôle 4 détermine des premières données d'évolution de l'intensité de photoluminescence $I_{PL}$ en fonction de la tension en circuit ouvert $V_{oc}$ pour les cellules d'apprentissage. Ces premières données d'évolution forment la courbe $C_1$ telle que représentée sur la figure 3. Cette courbe $C_1$ est ainsi déterminée à partir de données d'apprentissage constituées par les couples ($V_{ov_i}$, $I_{PL_i}$) et de la relation (1).

Lors d'une étape E07, le dispositif de contrôle 4 détermine la valeur de référence de l'intensité de photoluminescence $I_{PL,ref}$ à partir d'une valeur de tension en circuit ouvert de référence $V_{oc,ref}$ et à l'aide de la courbe $C_1$. Dans l'exemple de réalisation décrit ici, la tension en circuit ouvert de référence $V_{oc,ref}$ est choisie égale à la valeur moyenne de tension en circuit ouvert $\overline{V_{oc}}$. L'intensité de référence $I_{PL,ref}$ est donc égale à l'intensité de photoluminescence associée (ou couplée) à la tension de référence $V_{oc,ref}$, ici égale à $\overline{V_{oc}}$, sur la courbe $C_1$. En variante, la tension de référence $V_{oc,ref}$ pourrait être l'une quelconque des valeurs de tension $V_{oc}$ comprises entre la moyenne $\overline{V_{oc}}$ augmentée de deux fois l'écart type $\sigma$ et la moyenne $\overline{V_{oc}}$ diminuée de deux fois l'écart type $\sigma$, c'est-à-dire comprise dans l'intervalle $[\overline{V_{oc}} - 2\sigma; \overline{V_{oc}} + 2\sigma]$.

Le procédé passe ensuite aux étapes E08 à E011 permettant la détermination de deuxièmes données d'évolution relatives à la réponse de photoluminescence d'une cellule photovoltaïque produite par la ligne de production L en fonction du niveau d'éclairement appliqué à cette cellule. Par « réponse de photoluminescence », on entend ici désigner l'intensité de photoluminescence du signal de photons émis par la cellule en réponse à une excitation. Ces deuxièmes données d'évolution forment une deuxième courbe notée $C_2$ telle que représentée sur la figure 2. Notons que la courbe d'évolution $C_2$ peut être déterminée à partir d'une seule cellule d'apprentissage, voire de quelques cellules d'apprentissage. En effet, l'évolution de la réponse de photoluminescence d'une cellule produite par la ligne L en fonction du niveau d'éclairement est analogue, ou sensiblement analogue, d'une cellule à l'autre, quelle que soit notamment la tension en circuit ouvert de la cellule. Dans l'exemple de réalisation particulier décrit ici, les étapes E08 à E11 sont ici mises en oeuvre pour une cellule d'apprentissage, par exemple la cellule $CLA_1$. En variante, on pourrait réitérer ces étapes E08 à E011 pour un nombre limité de cellules d'apprentissage.

En référence à la figure 5B , lors de l'étape E08, on soumet la cellule CLA1 à un niveau de puissance laser $P_j$, l'indice j étant initialement égal à 1. Par exemple, le premier niveau de puissance laser appliqué $P_1$ correspond à 10% de la puissance laser maximale d'émission du dispositif laser 1.

Lors d'une étape E09, on mesure la réponse de photoluminescence de la cellule $CLA_1$, c'est-à-dire l'intensité de luminescence du signal de photons émis par celle-ci, notée $I_{PL_1}[P_j]$, en réponse à l'excitation laser de puissance $P_j$.

Les étapes E08 et E09 sont réitérées pour une pluralité de niveaux de puissance laser $P_j$, avec j=1, 2, 3, ..., M, allant par exemple de 10% à environ 80% de la puissance laser maximale du laser 1. On effectue par exemple une dizaine de mesures d'intensité de luminescence $I_{PL_1}[P_j]$ pour un nombre correspondant de niveaux de puissance laser différents.

Une étape de test E010 est prévue pour que le procédé revienne à l'étape E08 tant que l'indice j est inférieur à M (branche N sur la figure 5B). Lorsque la réponse de photoluminescence de la cellule $CLA_1$ a été mesurée pour les M niveaux d'éclairement $P_j$, avec j=1, 2, 3, ..., M, le procédé passe à l'étape E011 (branche Y sur la figure 5B).

A l'issue de l'étape E010, une fois que les étapes E08 et E09 ont été réitérés M fois, on obtient M couples de valeurs ($P_j$, $I_{PL_1}[P_j]$), avec j=1, 2, 3, ..., M.

Lors de l'étape E011, à partir des M couples de valeurs ($P_j$, $I_{PL_1}[P_j]$), le dispositif de contrôle 4 détermine des deuxièmes données d'évolution de l'intensité de photoluminescence d'une cellule photovoltaïque produite par la ligne de fabrication L en fonction du niveau d'éclairement. Ces deuxièmes données d'évolution formant la courbe $C_2$, telle que représentée sur la figure 2. Cette courbe $C_2$ est la même, ou sensiblement la même, pour toutes les cellules produites par la ligne de production L, quelles que soient leurs valeurs de $V_{oc}$ respectives. Dans le cas représenté sur la figure 2, la courbe C2 peut être ajustée par une loi polynomiale du type $\frac{I_{PL_1}[P_j]}{I_{PL_1}[P=40\%]} = a + b \cdot P_j + c \cdot P_j^2 + \cdots$

La phase d'apprentissage permet ainsi de déterminer les courbes d'évolution $C_1$ et $C_2$, basées sur des données d'apprentissage (c'est-à-dire des données de mesure relatives aux cellules d'apprentissage) et peut être réalisée à la première mise en service de la ligne de production L.

La phase d'apprentissage comprend également des étapes E012 et E013 permettant de déterminer un seuil critique de paramètre de quantification de défauts $TSH_{GL}$. Ces étapes E012 et E013 seront décrites plus loin.

Contrôle de qualité

On va maintenant décrire la phase de contrôle de qualité de cellules photovoltaïques produites par la ligne de production L, mise en oeuvre après la phase d'apprentissage. Notons $CLC_k$, avec k= 1, 2, ..., un ensemble de cellules photovoltaïques à contrôler.

Dans le mode de réalisation particulier décrit ici, le contrôle de qualité est mis en oeuvre pour chaque cellule à contrôler $CLC_k$, avant la fin du processus de fabrication de la cellule, et plus précisément avant métallisation de celle-ci.

Le contrôle de qualité comprend, pour chaque cellule à contrôler $CLC_k$ :

- une étape préalable E2 de détermination d'un niveau d'excitation ajusté à la cellule à contrôler $CLC_k$ ;
- une étape d'excitation E3, lors de laquelle ladite cellule $CLC_k$ est soumise à une excitation à un niveau d'excitation ajusté ;
- une étape E4 d'acquisition d'au moins une image de luminescence de la cellule $CLC_k$ après excitation ;

- une étape E5 de traitement de l'image acquise.

Ajustement du niveau d'excitation :

L'étape préalable E2 consiste à déterminer un niveau d'excitation, en l'espèce un niveau d'éclairement, ajusté à ladite cellule $CLC_k$. Par définition, un niveau d'excitation « ajusté » à une cellule photovoltaïque est un niveau d'excitation adapté de manière à ce que l'intensité de luminescence $I_{PL,k}$ du signal de photons émis par la cellule considérée, en réponse au niveau d'excitation appliqué, soit égale à l'intensité de référence $I_{PL,ref}$. Notons $P[CLC_k]$ le niveau d'excitation ajusté à la cellule $CLC_k$, correspondant ici à un niveau d'éclairement défini par un pourcentage de la puissance maximale d'émission du dispositif d'émission laser 1.

L'étape E2 comprend les sous-étapes E20 à E23 décrites ci-après, en référence à la figure 6A.

La sous-étape E20 consiste à soumettre la cellule à contrôler $CLC_k$ à un niveau d'excitation initial choisi $P_{init}$ à l'aide du dispositif d'émission laser 1. Le niveau d'excitation initial $P_{init}$ correspond à un niveau d'éclairement ici égal à 40% de la puissance laser maximale d'émission du dispositif laser 1.

Le capteur 2 mesure l'intensité de photoluminescence $I_{PL,k}[P_{init}]$ du signal de photons émis par la cellule $CLC_k$ en réponse à l'excitation $P_{init}$, lors de la sous-étape E21.

Lors de la sous-étape E22, le dispositif de contrôle 4 calcule un rapport d'intensités entre la valeur de référence d'intensité de luminescence et la valeur mesurée d'intensité de luminescence, c'est-à-dire entre $I_{PL,ref}$ et $I_{PL,k}[P_{init}]$. Notons $RI_k$ ce rapport d'intensités :

$$RI_k = \frac{I_{PL,ref}}{I_{PL,k}[P_{init}]}$$

Lors d'une étape E23, le dispositif de contrôle 4 détermine le niveau d'excitation $P[CLC_k]$ ajusté à la cellule $CLC_k$ à partir du rapport d'intensités $RI_k$ et à l'aide de la courbe $C_2$.

A ce rapport d'intensités $RI_k$ correspond un rapport de niveaux d'éclairement constituant un facteur d'ajustement $\alpha_k$ à appliquer au niveau d'excitation initial $P_{init}$ pour obtenir le niveau d'excitation $P[CLC_k]$ ajusté à la cellule $CLC_k$.

Dans le mode de réalisation particulier décrit ici, la courbe $C_2$ est normalisée pour le niveau d'éclairement initial choisi $P_{init}$. Cela signifie que la réponse de photoluminescence au niveau d'éclairement défini par $P_{init}$ (ici 40%) est ramenée à 1 et que l'ensemble des points de la courbe $C_2$ est adapté de façon analogue. Grâce à cela, le niveau d'éclairement ajusté $P[CLC_k]$ est donné directement par la courbe $C_2$ à partir du rapport $RI_k$ pris en tant que réponse de photoluminescence. En d'autres termes, le niveau d'éclairement ajusté à la cellule $CLC_k$ est le niveau d'éclairement associé sur la courbe $C_2$ à la réponse de photoluminescence égale au rapport d'intensités $RI_k$.

Prenons l'exemple d'une cellule à contrôler, par exemple $CLC_1$, à laquelle on applique un niveau d'éclairement initial choisi $P_{init}$ égal à 40% de la puissance maximale du dispositif d'émission laser 1. En référence à la figure 2, l'intensité de photoluminescence $I_{PL,1}[P_{init}]$ du signal de photons émis par la cellule $CLC_1$ en réponse à l'éclairement à $P_{init}$ (40%) est de l'ordre de 40000 photons. L'intensité de référence $I_{PL,ref}$ étant égale à 20000 photons sur la figure 2, le rapport d'intensités $RI_1$ vaut 0,5. Sur la courbe $C_2$, la valeur normalisée de réponse de photoluminescence de 0,5 ($RI_1$) correspond à un niveau d'éclairement de 25% de la puissance laser maximale. On détermine ainsi que le niveau d'éclairement ajusté à la cellule $CLC_1$ est égal à 25% de la puissance laser maximale.

Excitation

Lors de l'étape d'excitation E3, la cellule à contrôler $CLC_k$ est soumise à une excitation au niveau d'excitation ajusté déterminé lors de l'étape E2. Dans l'exemple particulier décrit ici, la cellule à contrôler $CLC_k$ est ainsi soumise à un éclairement ajusté dont le niveau est défini par la puissance $P[CLC_k]$ préalablement déterminé à l'étape E2.

Acquisition

Lors de l'étape E4, le dispositif d'acquisition 2 prend une image, notée $IM_{PL,k}$, de photoluminescence de la réponse de photoluminescence de la cellule $CLC_k$ suite à l'excitation au niveau d'éclairement $P[CLC_k]$. L'image de photoluminescence $IM_{PL,k}$ de ladite cellule à contrôler $CLC_k$ est composée d'un ensemble de pixels $p_i$ associés à des valeurs respectives d'intensité de luminescence, notées $IM_{PL,k,i}$, i représentant ici un indice de pixel. Autrement dit, une intensité de luminescence $IM_{PL,k,i}$ est attribuée à chaque pixel d'image $p_i$. Notons n le nombre total de pixels $p_i$ d'une image de photoluminescence acquise.

Traitement d'image

Le dispositif de contrôle 4 met ensuite en oeuvre une étape de traitement d'image E5 comportant les sous-étapes E50 à E53, décrites ci-après en référence à la figure 6B. Le traitement d'image E5 permet de déterminer un paramètre $GL_k$ de quantification des défauts de la cellule à contrôler $CLC_k$, à partir de l'image de photoluminescence $IM_{PL,k}$.

Lors de la sous-étape E50, le dispositif de contrôle 4 décompose l'image de luminescence $IM_{PL,k}$ de la cellule à contrôler CLCk en une première image $IM0_{PL,k}$ correspondant à ladite cellule sans défauts et une deuxième image $IMd_{PL,k}$ correspondant à des défauts de ladite cellule. Ainsi, on découple la réponse de photoluminescence de la cellule $CLC_k$ des effets dérivés de la présence de défauts dans la cellule. L'image $IM0_{PL,k}$ représente le fond de l'image d'origine $IM_{PL,k}$ et correspond à la réponse de photoluminescence de la cellule $CLC_k$ sans défauts.

Pour obtenir la première image $IM0_{PL,k}$, on peut par exemple décomposer l'image originale $IM_{PL,k}$ en choisissant N pixels de cette image originale. Ces N pixels peuvent avantageusement être situés à des emplacements périodiquement espacés. Ils forment une matrice de pixels.

On attribue ensuite à chacun de ces N pixels une valeur qui est représentative de son environnement local direct. L'environnement local d'un pixel donné est défini par une zone spatiale contenant ce pixel, par exemple une zone carrée dont le centre est le pixel choisi. La taille de cette zone d'environnement local est adaptée pour être plus grande que les défauts courants susceptibles de concerner la cellule, qui sont généralement bien connus.

La valeur attribuée à chacun des N pixels choisis est la valeur de pixel la plus élevée de la zone entourant ce pixel et constituant son environnement local.

Ensuite, on attribue une nouvelle valeur à chaque pixel de l'image à partir des valeurs attribuées aux N pixels choisis afin d'obtenir une première image correspondant à la cellule sans défauts. Avantageusement, les nouvelles valeurs des pixels d'image sont déterminées par interpolation des valeurs attribuées aux N pixels choisis. Autrement dit, par calcul d'interpolation, on réattribue une nouvelle valeur à chaque pixel de l'image, hormis aux N pixels initialement choisis (qui ont la valeur la plus élevée de leur environnement). On obtient ainsi la première image $IM0_{PL,k}$ correspondant à ladite cellule sans défauts.

Au lieu d'attribuer à chacun des N pixels choisis la valeur de pixel la plus élevée de son environnement local, on pourrait lui attribuer une autre valeur représentative de son environnement local, par exemple une moyenne des valeurs des pixels de cet environnement local.

Ensuite, on détermine la deuxième image $IMd_{PL,k}$ correspondant à des défauts de ladite cellule à partir de l'image de luminescence (ou image originale) $IM_{PL,k}$ et de la première image $IM0_{PL,k}$. La deuxième image $IMd_{PL,k}$ des défauts de la cellule est obtenu soit en réalisant un ratio entre l'image d'origine $IM_{PL,k}$ et l'image sans défauts $IM0_{PL,k}$, soit en réalisant une soustraction entre l'image d'origine $IM_{PL,k}$ et l'image sans défauts $IM0_{PL,k}$.

Cette méthode permet de reconstruire l'image en éliminant les zones où la réponse de photoluminescence est faible, c'est-à-dire des zones considérées comme des défauts, de manière à obtenir la première image $IM0_{PL,k}$ correspondant à l'image de la cellule sans défauts.

Chaque image ($IM_{PL,k}$, $IM0_{PL,k}$, $IMd_{PL,k}$) contient n pixels d'indice respectifs i et affectés de valeurs respectives d'intensité de luminescence ($I_{PL,k,i}$, $I0_{PL,k,i}$, $Id_{PL,k,i}$).

Lors de la sous-étape E51, le dispositif de contrôle 4 calcule une valeur moyenne des intensités de luminescence attribuées aux pixels de l'image des défauts $IMd_{PL,k}$, à l'aide de l'équation suivante :

$$G_{d,k} = \frac{\sum_{i=1}^{n} Id_{PL,k,i}}{n} \quad (2)$$

où

- $Id_{PL,k,i}$ représente l'intensité de photoluminescence associée à un pixel d'indice i de l'image $IMd_{PL,k}$ ;
- $n$ représente le nombre total de pixels dans l'image considérée.

Le résultat $G_{d,k}$ de l'équation (2) constitue un premier paramètre de quantification des défauts de la cellule à contrôler $CLC_k$.

Lors de la sous-étape E52, le dispositif de contrôle 4 calcule une valeur moyenne des intensités de luminescence associées aux pixels de l'image sans défaut $IM0_{PL,k}$, à l'aide de l'équation suivante :

$$G_{0,k} = \frac{\sum_{i=1}^{n} I0_{PL,k,i}}{n} \quad (3)$$

où

- $I0_{PL,k,i}$ représente l'intensité de photoluminescence associée à un pixel d'indice i de l'image $IM0_{PL,k}$ ;
- $n$ représente le nombre total de pixels dans l'image considérée.

Lors de la sous-étape E53, le dispositif de contrôle 4 corrige le premier paramètre de quantification des défauts $G_{d,k}$ à l'aide de la moyenne $G_{0,k}$ selon l'équation suivante :

$$GL_k = \frac{G_{d,k}}{1-G_{0,k}} \qquad (4)$$

Le résultat de cette équation $GL_k$ constitue le paramètre corrigé de quantification des défauts de la cellule $CLC_k$.

La pondération du paramètre $G_{dk}$ par l'élément $\left(\frac{1}{1-G_{0,k}}\right)$ permet de corriger d'éventuelles déviations causées par des imprécisions dans les niveaux d'éclairement ajustés appliqués aux différentes cellules. Idéalement, le paramètre $G_{0,k}$ est le même pour toutes les cellules à contrôler, dans la mesure où les niveaux d'éclairement ont été réglés, ou ajustés, pour que les intensités de photoluminescence soient toutes identiques (égales à l'intensité de luminescence de référence $I_{PL,ref}$). Toutefois, en pratique, l'intensité de luminescence $I_{PL,k}$ émise par une cellule à contrôler $CLC_k$ en réponse à un niveau d'éclairement ajusté peut légèrement dévier par rapport à l'intensité de luminescence de référence $I_{PL,ref}$ visée, en raison par exemple d'une légère erreur de réglage du dispositif d'émission laser 1. Il en résulte soit une surestimation, soit une sous-estimation du paramètre $G_{d,k}$ de quantification des défauts, respectivement dans le cas où $I_{PL,k}$ est supérieure ou inférieure à $I_{PL,ref}$. L'élément $\left(\frac{1}{1-G_{0,k}}\right)$ constitue un facteur de correction du paramètre $G_{d,k}$, qui permet de compenser les éventuelles déviations de l'intensité de luminescence de la cellule à contrôler $CLC_k$.

Corrélation entre paramètres GL et $\Delta$FF

Sur la figure 7, on a représenté les caractéristiques courant-tension (courbe $C_{I_V}$) et puissance-tension (courbe $C_P$) d'une cellule photovoltaïque. Sur cette figure 7 :

- « $I_{SC}$ » représente le courant en court-circuit de la cellule, c'est-à-dire le courant débité par la cellule lorsque la tension à ses bornes est nulle (V=0) ;
- « $V_{OC}$ » représente la tension en circuit ouvert de la cellule, c'est-à-dire la tension aux bornes de la cellule lorsque le courant débité est nul (I=0) ;
- « $I_{mp}$ » et « $V_{mp}$ » représentent respectivement le courant et la tension d'un point de fonctionnement de la cellule pour lequel la puissance fournie par celle-ci est maximale.

Par définition, le facteur de forme d'une cellule photovoltaïque est égal à

$$FF = \frac{V_{mp}.I_{mp}}{V_{OC}.I_{SC}}$$

Le facteur de forme FF est le rapport entre la puissance maximale fournie par la cellule et la puissance idéale qu'elle fournirait si elle était parfaite, sans défaut. Ce facteur FF représente en définitive le degré d'idéalité de la cellule et constitue un paramètre indicatif des performances de la cellule. Certains défauts (par exemple des impuretés chimiques, des microfractures, des dislocations, etc.) sont susceptibles d'apparaître dans la cellule lors de sa fabrication et de faire diminuer le facteur de forme FF. Notons $\Delta$FF, un paramètre de perte de facteur de forme, représentant une amplitude de diminution du facteur de forme.

Comme précédemment indiqué, la phase d'apprentissage du procédé comprend une étape E012 de détermination d'une corrélation entre les paramètres de quantification des défauts $GL_i$ et le paramètre de perte de facteur de forme $\Delta FF_i$, pour les cellules d'apprentissage $CLA_i$ (i allant de 1 à N). Cette étape E012 comprend, pour chaque cellule d'apprentissage $CLA_i$ :

- une première sous-étape E0120 consistant à mesurer une perte de facteur de forme, soit $\Delta FF_i$, pour la cellule $CLA_i$ ;
- une deuxième sous-étape E0121 consistant à calculer le paramètre $GL_i$ pour la cellule d'apprentissage $CLA_i$.

Les étapes E0120 et E0121 sont réitérées pour chacune des cellules d'apprentissage (test E0122).

Lors de l'étape E0120, la perte de facteur de forme $\Delta FF_i$ est évaluée pour une cellule d'apprentissage finie, après métallisation. Par exemple, la perte de facteur de forme $\Delta FF_i$ peut être définie comme une différence entre le facteur de forme réel mesuré pour la cellule $CLA_i$ et un facteur de forme de référence et pour la cellule $CLA_i$. En variante, on pourrait utiliser une méthode plus précise de quantification de $\Delta FF_i$ prenant en compte différents phénomènes physiques qui impactent le facteur de forme (résistance série, résistance shunt, recombinaisons, ...), telle que celle décrite dans l'article « A Fill Factor Loss Analysis Method for Silicon Wafer Solar Cells » IEEE Journal of photovoltaics, vol.3, N°4, october 2013, Digital Objet Identifier 10.1109/JPHOTOV.2013.2270348.

La sous-étape E0121 consiste à mettre en oeuvre l'étape E5 de calcul du paramètre de quantification des défauts $GL_i$ pour la cellule d'apprentissage $CLA_i$, après avoir réalisé les étapes E2 à E4 consistant à déterminer le niveau d'éclairement ajusté à la cellule $CLA_i$, à exciter la cellule $CLA_i$ avec le niveau d'éclairement initial choisi $P_{init}$ et à acquérir une image de photoluminescence de la cellule $CLA_i$ en réponse à l'éclairement ajusté.

A l'issue de l'étape E012, le dispositif 4 mémorise des données d'évolution du paramètre de perte de facteur de forme $\Delta FF$ en fonction du paramètre de quantification des défauts GL, comme représenté sur la figure 8.

Lors d'une étape E013, le dispositif 4 détermine un seuil critique de paramètre de quantification des défauts, noté $TSH_{GL}$, au-delà duquel les pertes de facteur de forme sont estimées trop importantes pour que les performances de la cellule soient satisfaisantes. Par exemple, en référence à la figure 8, ce seuil $TSH_{GL}$ est fixé à 4,75. Bien entendu, ce seuil pourrait être différent avec une autre ligne de production de cellules.

Sélection des cellules contrôlées $CLC_k$

La phase de contrôle de qualité de chaque cellule à contrôler $CLC_k$ comprend, suite à l'étape de détermination du paramètre $GL_k$ de la cellule (étape E5), une étape de test E6 consistant à déterminer si les performances de la cellule $CLC_k$ sont satisfaisantes. Le test E6 consiste à déterminer si le paramètre de quantification des défauts $GL_k$ est supérieur ou égal au seuil critique $TSH_{GL}$.

Si le test est négatif, la qualité de la cellule $CLC_k$ est jugée satisfaisante et la cellule $CLC_k$ peut passer à une étape suivante de son processus de fabrication, en l'espèce à une étape de métallisation E7.

Si le test est positif, les performances de la cellule $CLC_k$ sont considérées comme insuffisantes et la cellule $CLC_k$ est retirée de la ligne de production L (étape E8).

Dans l'exemple de réalisation qui vient d'être décrit ici, le procédé de contrôle de qualité est mis en oeuvre avant l'étape de métallisation de la cellule mise en oeuvre en fin de fabrication. Grâce à cela, les cellules défectueuses peuvent être retirées de la ligne de production avant métallisation, ce qui permet d'économiser du métal. On pourrait toutefois envisager de mettre en oeuvre le procédé de contrôle de qualité à la fin de la fabrication des cellules.

Les différentes étapes du procédé sont mises en oeuvre par ou sous le contrôle des modules correspondants du dispositif de contrôle 4, notamment :

- le module d'apprentissage 40 est apte à mettre en oeuvre les étapes de la phase d'apprentissage ;
- le module 41 de détermination d'excitation est apte à mettre en oeuvre l'étape E2 de détermination d'un niveau d'excitation ;
- le module 42 de traitement d'image est apte à mettre en oeuvre l'étape E5 de traitement d'image. ;
- la module 44 de sélection de cellule est apte à mettre en oeuvre les étapes E6 à E8.

Dans le mode de réalisation particulier qui vient d'être décrit, il est prévu une phase d'apprentissage (étape E00 à E011) permettant de déterminer les courbes d'évolution $C_1$ et $C_2$, puis, pour chaque cellule $CLC_k$, une étape E2 de détermination d'un niveau d'excitation ajusté $P[CLC_k]$ à la cellule considérée $CLC_k$.

Dans un autre mode de réalisation particulier, les cellules $CLC_k$ sont excitées à un niveau d'excitation prédéfini, non adaptatif, qui peut être le même pour toutes les cellules. Le niveau d'excitation d'une cellule à contrôler $CLC_k$ n'est dans ce cas pas ajusté à la cellule considérée. Un niveau d'excitation typique est de l'ordre de 1 soleil. Ce niveau d'excitation peut toutefois être plus bas ou plus élevée, notamment compris entre 0.1 et 10 soleils. Dans ce cas, le procédé de contrôle de qualité des cellules $CLC_k$ est analogue à celui qui vient d'être décrit, à la différence près qu'il ne comprend pas ni phase d'apprentissage (étapes E00 à E011), ni étape (E2) de détermination d'un niveau d'excitation ajusté à chaque cellule. Le procédé selon cet autre mode de réalisation comprend, pour chaque cellule :

- une étape d'excitation E3, lors de laquelle la cellule à contrôler $CLC_k$ est soumise à une excitation à un niveau d'excitation prédéfini (non spécifiquement ajusté à la cellule) ;

- une étape E4 d'acquisition d'au moins une image $IM_{PL,k}$ de luminescence de la cellule à contrôler $CLC_k$ après excitation ;
- une étape E5 de traitement de l'image acquise $IM_{PL,k}$.

Lors de l'étape de traitement E5, l'image de luminescence de chaque cellule à contrôler CLCk est décomposée en une première image correspondant à la cellule sans défauts et une deuxième image correspondant à des défauts de ladite cellule (étape E50). Une image de luminescence de cellule étant composée d'un ensemble de pixels auxquels des valeurs respectives d'intensité de luminescence sont attribuées, pour décomposer l'image $IM_{PL,k}$. :

- on choisit une pluralité N de pixels de ladite image de luminescence $IM_{PL,k}$. ;
- on attribue à chacun des pixels choisis une valeur qui est représentative d'un environnement local dudit pixel ;
- on attribue une nouvelle valeur à chaque pixel de l'image à partir des valeurs des pixels choisis afin d'obtenir la première image $IM0_{PL,k}$ ;
- on détermine la deuxième image $IMd_{PL,k}$, par exemple en réalisant un ratio ou une soustraction entre l'image de luminescence de la cellule $IM_{PL,k}$. et la première image $IM0_{PL,k}$.

Les pixels choisis de l'image de luminescence peuvent être situés à des emplacements périodiquement espacés. L'environnement local d'un pixel choisi est une zone contenant le pixel choisi, par exemple un carré centré sur celui-ci. La nouvelle valeur attribuée à chaque pixel de l'image est par exemple obtenue par interpolation des valeurs des pixels choisis.

On calcule ensuite (étape E51) une moyenne des valeurs d'intensité de luminescence associées aux pixels de la deuxième image afin de déterminer un paramètre de quantification des défauts de la cellule, comme précédemment explicité.

Pour la mise en oeuvre de cet autre mode de réalisation, le système de contrôle est analogue à celui précédemment décrit, à la différence près que le dispositif de contrôle 4 ne comprend pas ni module d'apprentissage 40, ni module 41 de détermination d'un niveau d'excitation ajusté. Ainsi le système comprend un dispositif d'excitation adapté pour appliquer une excitation à une cellule à contrôler, un dispositif d'acquisition d'une image de luminescence de la cellule après excitation et un dispositif de contrôle comportant un module de traitement d'image 42, un module 43 d'évaluation d'un paramètre de perte de facteur de forme et un module 44 de sélection de cellule. Le module 42 de traitement d'image est adapté pour décomposer l'image de luminescence de chaque cellule à contrôler en une première image correspondant à la cellule sans défauts et une deuxième image correspondant à des défauts de la cellule, notamment pour choisir une pluralité N de pixels de ladite image de luminescence, attribuer à chacun des pixels choisis une valeur qui est représentative d'un environnement local dudit pixel, attribuer une nouvelle valeur à chaque pixel de l'image à partir des valeurs des pixels choisis afin d'obtenir la première image, déterminer la deuxième image à partir de l'image de luminescence et de la première image. En outre, le module de traitement d'image peut être adapté pour calculer une moyenne des valeurs d'intensité de luminescence associées aux pixels de la deuxième image afin de déterminer un paramètre de quantification des défauts de la cellule.

## Revendications

**1.** Procédé de contrôle de qualité d'une pluralité de cellules photovoltaïques ($CLC_k$) comprenant, pour chaque cellule :

• une étape d'excitation (E3), lors de laquelle la cellule à contrôler ($CLC_k$) est soumise à une excitation avec un niveau d'excitation déterminé ;
• une étape (E4) d'acquisition d'au moins une image ($IM_{PL,k}$) de luminescence de la cellule à contrôler ($CLC_k$) après excitation ;
• une étape (E5) de traitement de l'image acquise ($IM_{PL,k}$) ;

**caractérisé en ce qu'**il est prévu, pour chaque cellule ($CLC_k$), une étape préalable (E2) de détermination d'un niveau d'excitation ajusté ($P[CLC_k]$) à ladite cellule ($CLC_k$), les niveaux d'excitation ajustés respectifs des différentes cellules à contrôler étant adaptés de manière à ce que les intensités de luminescence ($I_{PL,k}$) des signaux émis par les différentes cellules soient égales à une même intensité de luminescence de référence ($I_{PL,ref}$).

**2.** Procédé selon la revendication 1, **caractérisé en ce que**, lors de l'étape préalable (E2) de détermination du niveau d'excitation ajusté à la cellule :

• on mesure (E20) l'intensité de luminescence ($I_{PL,k}[P_{init}]$) émise par la cellule en réponse à un niveau d'excitation

initial choisi ($P_{init}$) ;
• on détermine (E23) le niveau d'excitation ajusté $P[CLC_k]$ à la cellule ($CLC_k$) à partir de l'intensité de luminescence mesurée, de l'intensité de luminescence de référence ($I_{PL,ref}$) et de données ($C_2$) d'évolution d'une réponse de luminescence d'une cellule en fonction du niveau d'excitation appliqué à ladite cellule.

**3.** Procédé selon la revendication 2, **caractérisé en ce qu'**on calcule (E22) un rapport d'intensités entre l'intensité de luminescence de référence et l'intensité de luminescence mesurée, et, les données d'évolution de la réponse de luminescence en fonction du niveau d'excitation appliqué étant normalisées pour le niveau d'excitation initial choisi, on obtient directement le niveau d'excitation ajusté à la cellule à l'aide desdites données d'évolution, à partir dudit rapport d'intensités pris en tant qu'intensité de luminescence.

**4.** Procédé selon l'une des revendications 1 à 3, **caractérisé en ce que**, les cellules à contrôler étant fabriquées par une ligne de fabrication, il est prévu une phase d'apprentissage, lors de laquelle :

• on mesure (E01) les tensions en circuit ouvert d'une pluralité de cellules d'apprentissage fabriquées sur ladite ligne de fabrication ;
• on détermine (E02) une tension en circuit ouvert de référence, contenue dans une plage définie par une moyenne des tensions en circuit ouvert mesurées plus ou moins de deux fois l'écart type de distribution des tensions en circuit ouvert mesurées;
• on détermine (E07) l'intensité de luminescence de référence à partir de la tension en circuit ouvert de référence déterminée et pour le niveau d'excitation initial choisi.

**5.** Procédé selon la revendication précédente, **caractérisé en ce que**, lors de la phase d'apprentissage

• on soumet (E03) les cellules d'apprentissage au niveau d'excitation initial choisi et on mesure (E04) les intensités de luminescence des cellules d'apprentissage en réponse à l'excitation ;
• on détermine (E06) des données d'évolution de l'intensité de luminescence des cellules d'apprentissage soumises au niveau d'excitation initial choisi, en fonction de la tension en circuit ouvert desdites cellules d'apprentissage.

**6.** Procédé selon l'une des revendications 1 à 5, **caractérisé en ce que**, pour chaque cellule à contrôler, l'image de luminescence de ladite cellule étant composée d'un ensemble de pixels auxquels des valeurs respectives d'intensité de luminescence sont attribuées, lors de l'étape de traitement :

• on décompose (E50) l'image de luminescence de la cellule à contrôler en une première image correspondant à ladite cellule sans défauts et une deuxième image correspondant à des défauts de ladite cellule,
• on calcule (E51) une moyenne des valeurs d'intensité de luminescence associées aux pixels de la deuxième image afin de déterminer un paramètre de quantification des défauts de la cellule.

**7.** Procédé selon la revendication précédente, **caractérisé en ce que** pour décomposer l'image de luminescence de la cellule à contrôler :

• on choisit une pluralité (N) de pixels de ladite image de luminescence ;
• on attribue à chacun des pixels choisis une valeur qui est représentative d'un environnement local dudit pixel ;
• on attribue une nouvelle valeur à chaque pixel de l'image à partir des valeurs des pixels choisis afin d'obtenir la première image ;
• on détermine la deuxième image à partir de l'image de luminescence et de la première image.

**8.** Procédé selon la revendication 6 ou 7, **caractérisé en ce que** le paramètre de quantification des défauts est corrigé (E53) par un facteur de correction déterminé à partir d'une moyenne de valeurs des pixels de la première image.

**9.** Procédé selon l'une des revendications 6 à 8, **caractérisé en ce que**, lors d'une phase d'apprentissage, on détermine (E012) des données de corrélation entre un paramètre de perte de facteur de forme et le paramètre de quantification des défauts, pour des cellules d'apprentissage.

**10.** Procédé selon la revendication précédente, **caractérisé en ce que**, pour chaque cellule à contrôler, on évalue (E0120) un paramètre de perte de facteur de forme de ladite cellule à partir du paramètre de quantification des défauts déterminé et desdites données de corrélation.

**11.** Procédé selon l'une des revendications précédentes, **caractérisé en ce que** :

- il est mis en oeuvre, pour chaque cellule à contrôler, avant ou après une étape de métallisation de ladite cellule, en cours de fabrication, et/ou
- lors de l'étape d'excitation, on soumet la cellule à un éclairement d'excitation, et/ou
- lors de l'étape d'excitation, on soumet la cellule à un courant d'excitation.

**12.** Système de contrôle de qualité d'une pluralité de cellules photovoltaïques comprenant des moyens matériels et logiciels pour mettre en oeuvre les étapes du procédé selon l'une des revendications précédentes et/ou comprenant :

• un dispositif d'excitation (1) adapté pour appliquer à une cellule à contrôler une excitation avec un niveau d'excitation déterminé ;
• un dispositif (2) d'acquisition d'une image de luminescence de la cellule après excitation ;
• un module de traitement d'image (42) ;

**caractérisé en ce qu'**il comprend un module (41) de détermination de niveaux d'excitation ajustés à des cellules à contrôler, adapté pour ajuster les niveaux d'excitation respectifs des cellules à contrôler de manière à ce que les intensités de luminescence émises par lesdites cellules soit égales à une même intensité de luminescence de référence.

**13.** Système selon la revendication 12, **caractérisé en ce que** le module (41) de détermination de niveaux d'excitation ajustés aux cellules à contrôler est agencé pour déterminer le niveau d'excitation ajusté pour une cellule à contrôler à partir d'une intensité de luminescence mesurée de ladite cellule en réponse à un niveau d'excitation initial choisi, de l'intensité de luminescence de référence et de données d'évolution d'une réponse de luminescence d'une cellule en fonction du niveau d'excitation appliqué à ladite cellule et/ou **en ce qu'**il comprend un module d'apprentissage (40) adapté pour déterminer

• une tension en circuit ouvert de référence, à partir de tensions en circuit ouvert mesurées de cellules d'apprentissage, ladite tension en circuit ouvert de référence étant contenue dans une plage définie par une moyenne des tensions en circuit ouvert mesurées plus ou moins de deux fois l'écart type de distribution des tensions en circuit ouvert mesurées, et
• l'intensité de luminescence de référence à partir de la tension en circuit ouvert de référence déterminée et pour le niveau d'excitation initial choisi,

et/ou **en ce qu'**il comprend un module (43) d'évaluation d'un paramètre de perte de facteur de forme d'une cellule à contrôler à partir du paramètre déterminé de quantification des défauts de ladite cellule et de données de corrélation entre le paramètre de perte de facteur de forme et le paramètre de quantification des défauts.

**14.** Système selon l'une des revendications 12 à 13, **caractérisé en ce que** le module de traitement d'image (42) est adapté pour décomposer l'image de luminescence d'une cellule à contrôler, acquise après excitation de ladite cellule au niveau d'excitation ajusté, en une première image correspondant à ladite cellule sans défauts et une deuxième image correspondant à des défauts de ladite cellule, et **en ce qu'**il comprend un module de détermination d'un paramètre de quantification de défauts de la cellule à contrôler agencé pour calculer une moyenne des valeurs d'intensité de luminescence associées aux pixels de la deuxième image.

**15.** Système selon la revendication précédente, **caractérisé en ce que** le module de traitement d'image (42) est adapté pour choisir une pluralité (N) de pixels de ladite image de luminescence, attribuer à chacun des pixels choisis une valeur qui est représentative d'un environnement local dudit pixel, attribuer une nouvelle valeur à chaque pixel de l'image à partir des valeurs des pixels choisis afin d'obtenir la première image, et déterminer la deuxième image à partir de l'image de luminescence et de la première image.

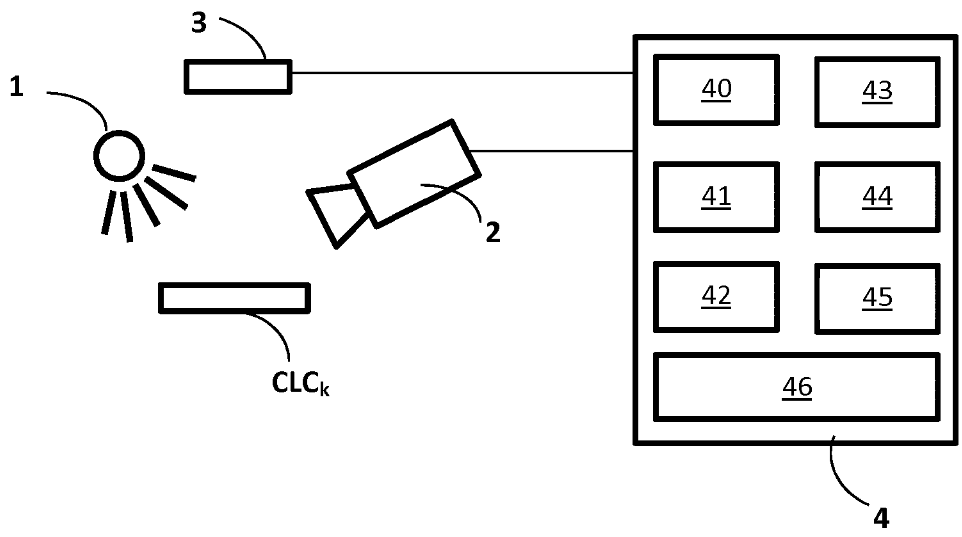


**Figure 1**

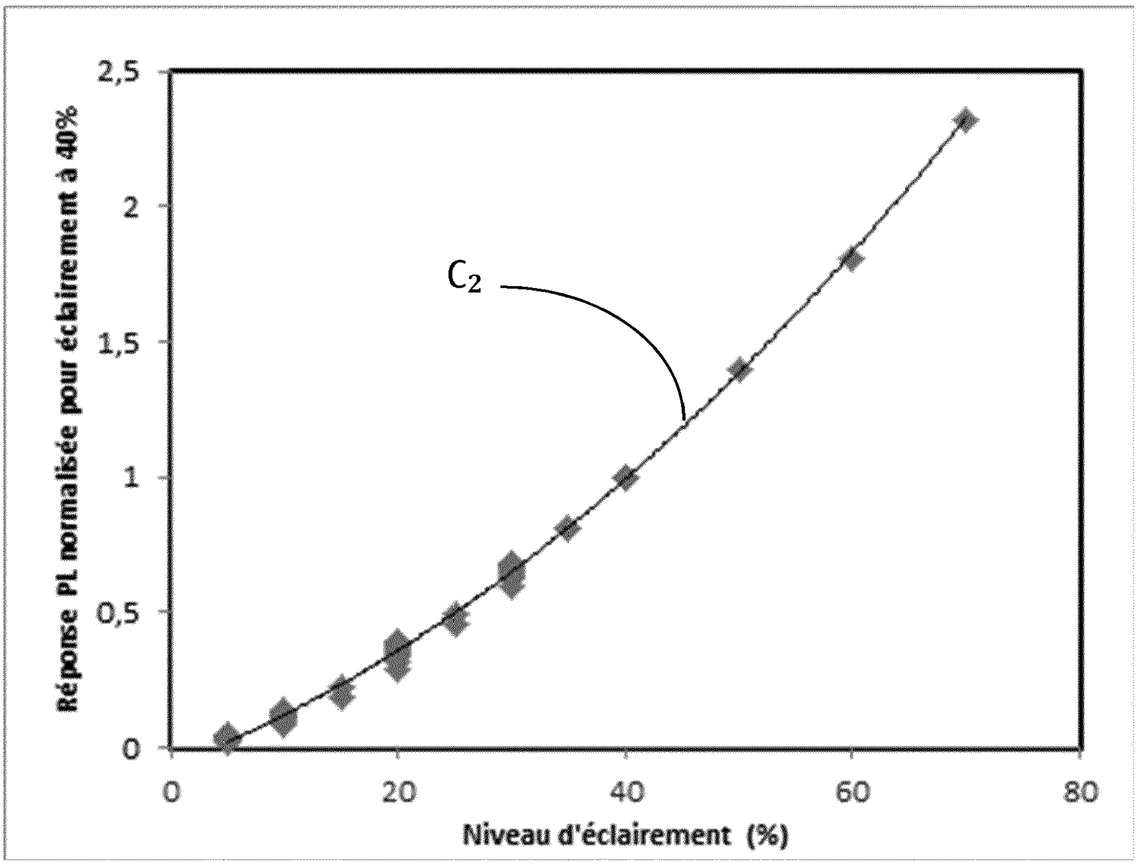


**Figure 2**

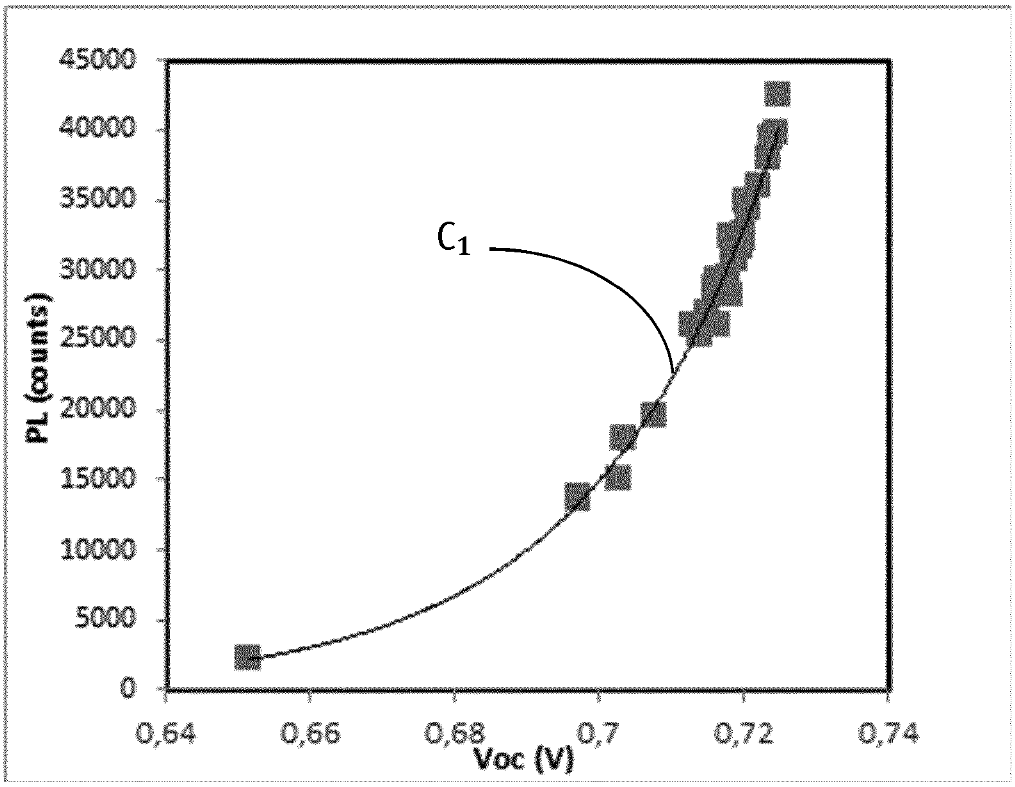


Figure 3

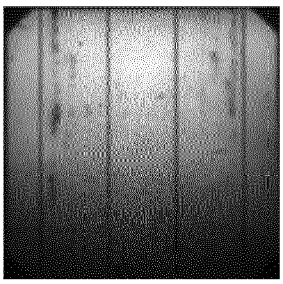

Figure 4A

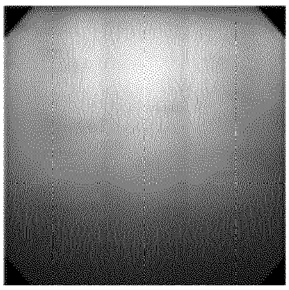

Figure 4B

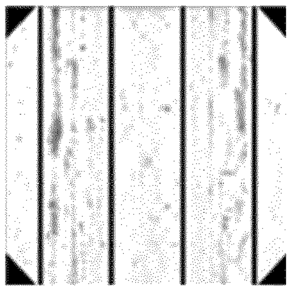

Figure 4C

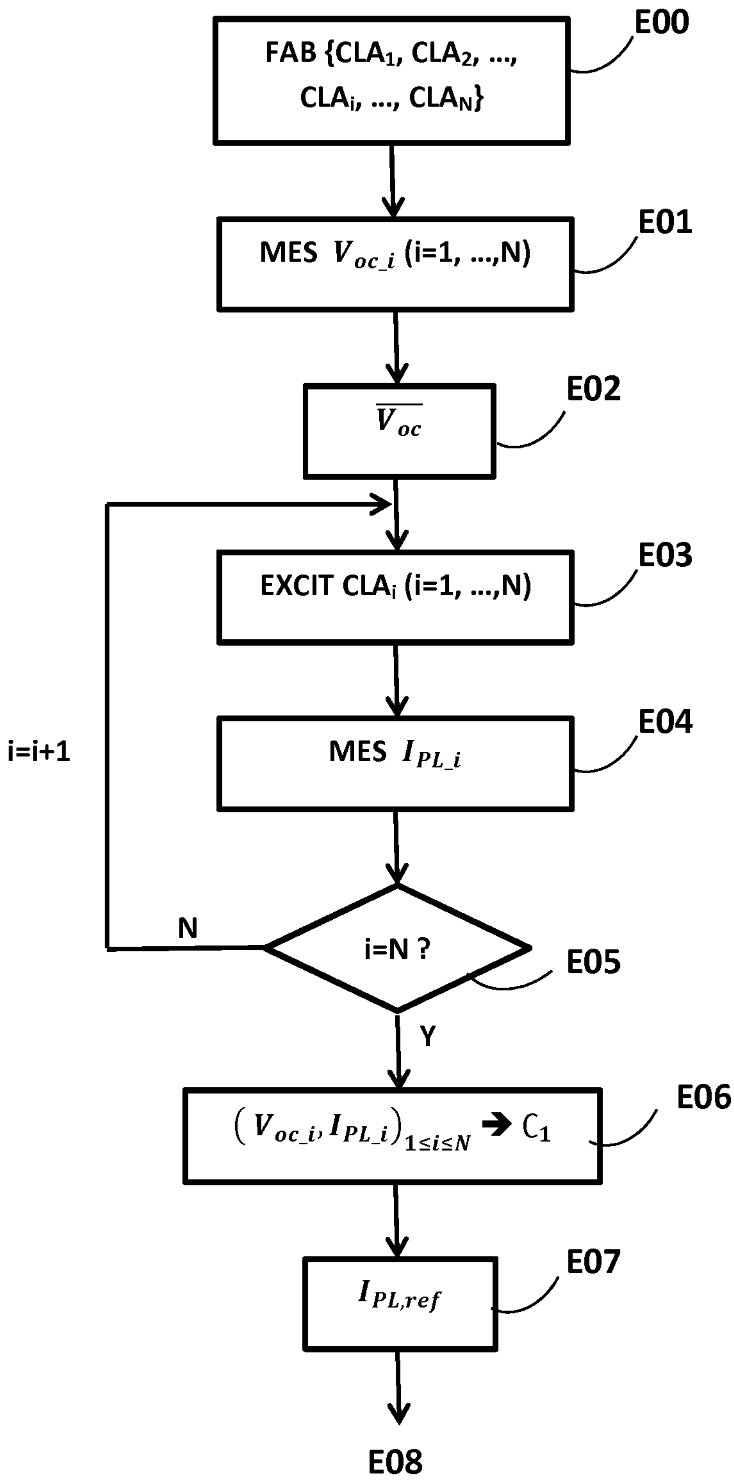

FAB {$CLA_1$, $CLA_2$, ..., $CLA_i$, ..., $CLA_N$}
E00
MES $V_{oc_i}$ (i=1, ...,N)
E01
$\overline{V_{oc}}$
E02
EXCIT $CLA_i$ (i=1, ...,N)
E03
MES $I_{PL_i}$
E04
i=i+1
N
i=N ?
E05
Y
$\left(V_{oc_i}, I_{PL_i}\right)_{1 \leq i \leq N}$ ➔ $C_1$
E06
$I_{PL,ref}$
E07
E08


**Figure 5A**

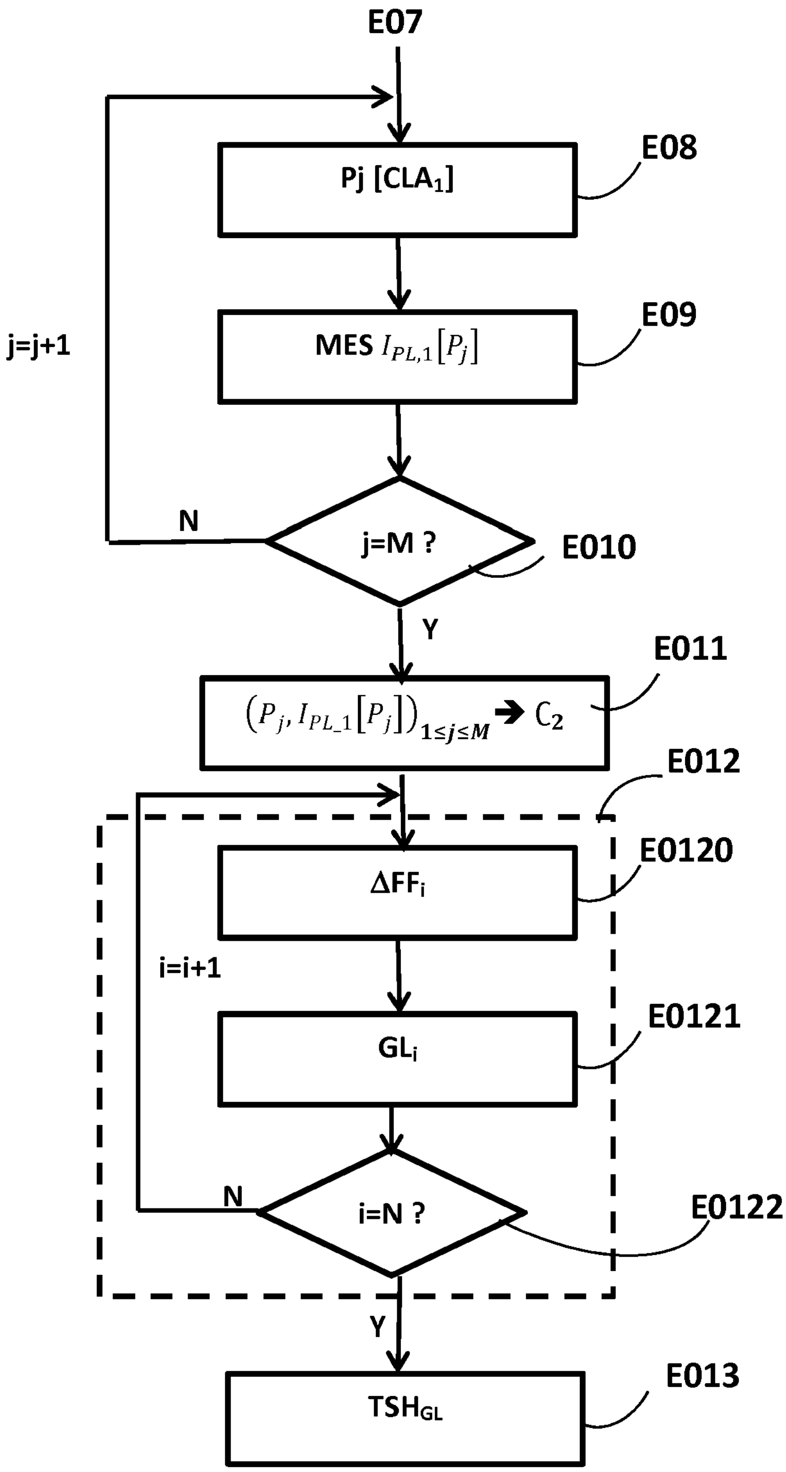
E07
Pj [CLA1]
E08
j=j+1
MES $I_{PL,1}[P_j]$
E09
N
j=M ?
E010
Y
$(P_j, I_{PL_1}[P_j])_{1 \le j \le M}$ ➔ C2
E011
E012
ΔFFi
E0120
i=i+1
GLi
E0121
N
i=N ?
E0122
Y
TSHGL
E013

Figure 5B

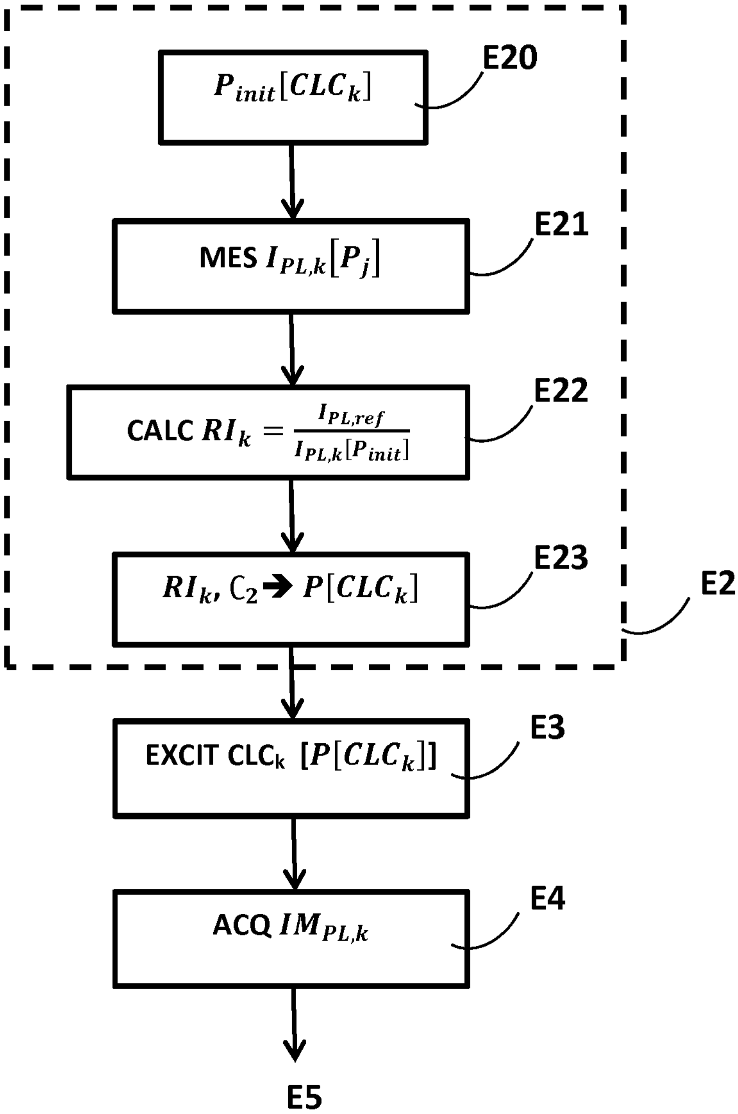
$P_{init}[CLC_k]$
E20
MES $I_{PL,k}[P_j]$
E21
CALC $RI_k = \frac{I_{PL,ref}}{I_{PL,k}[P_{init}]}$
E22
$RI_k$, $C_2$ ➔ $P[CLC_k]$
E23
E2
EXCIT $CLC_k$ $[P[CLC_k]]$
E3
ACQ $IM_{PL,k}$
E4
E5

Figure 6A

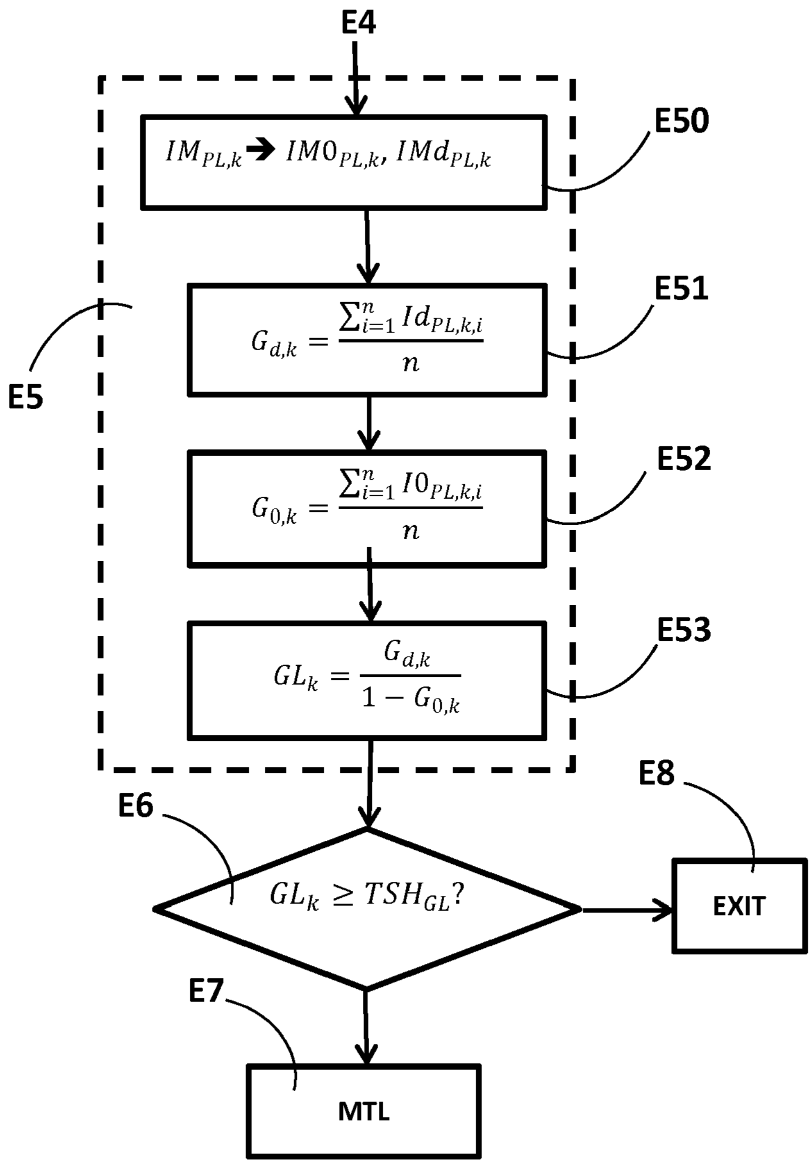
E4
E50
$IM_{PL,k} \rightarrow IM0_{PL,k}, IMd_{PL,k}$
E51
$G_{d,k} = \frac{\sum_{i=1}^{n} Id_{PL,k,i}}{n}$
E5
E52
$G_{0,k} = \frac{\sum_{i=1}^{n} I0_{PL,k,i}}{n}$
E53
$GL_k = \frac{G_{d,k}}{1 - G_{0,k}}$
E6
E8
$GL_k \geq TSH_{GL}?$
EXIT
E7
MTL

Figure 6B

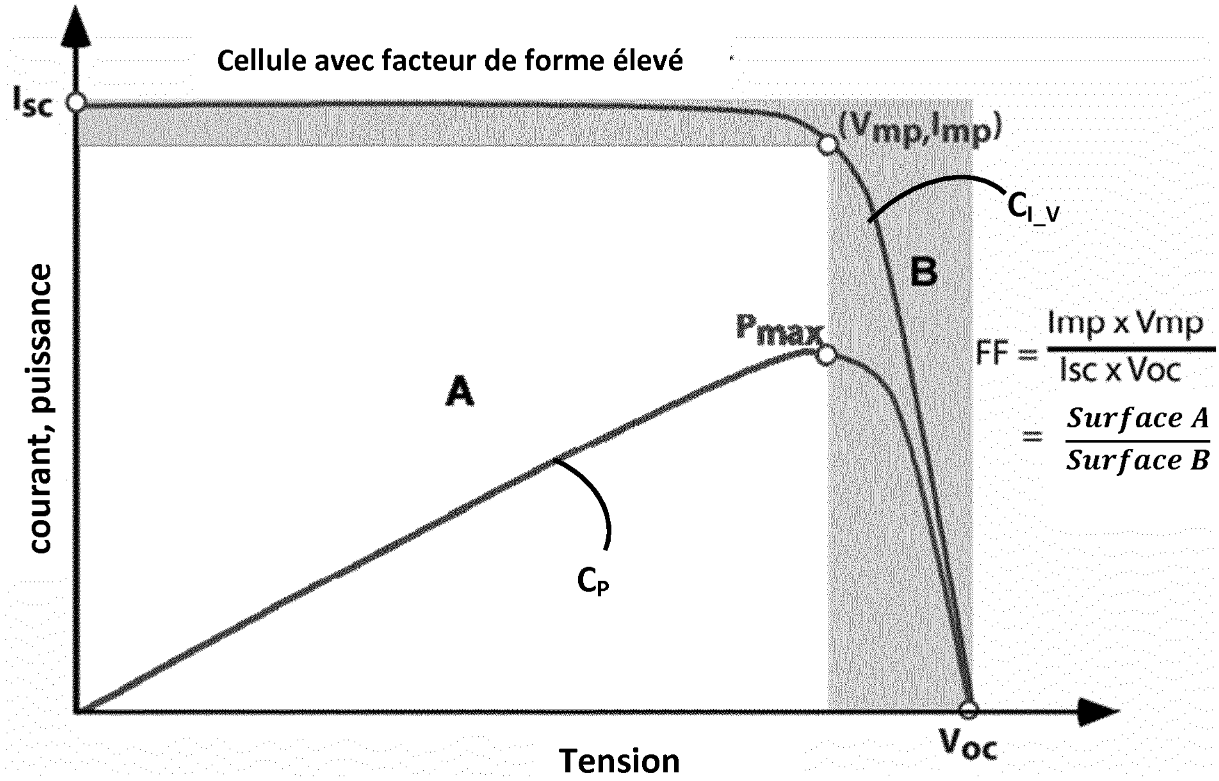


Figure 7

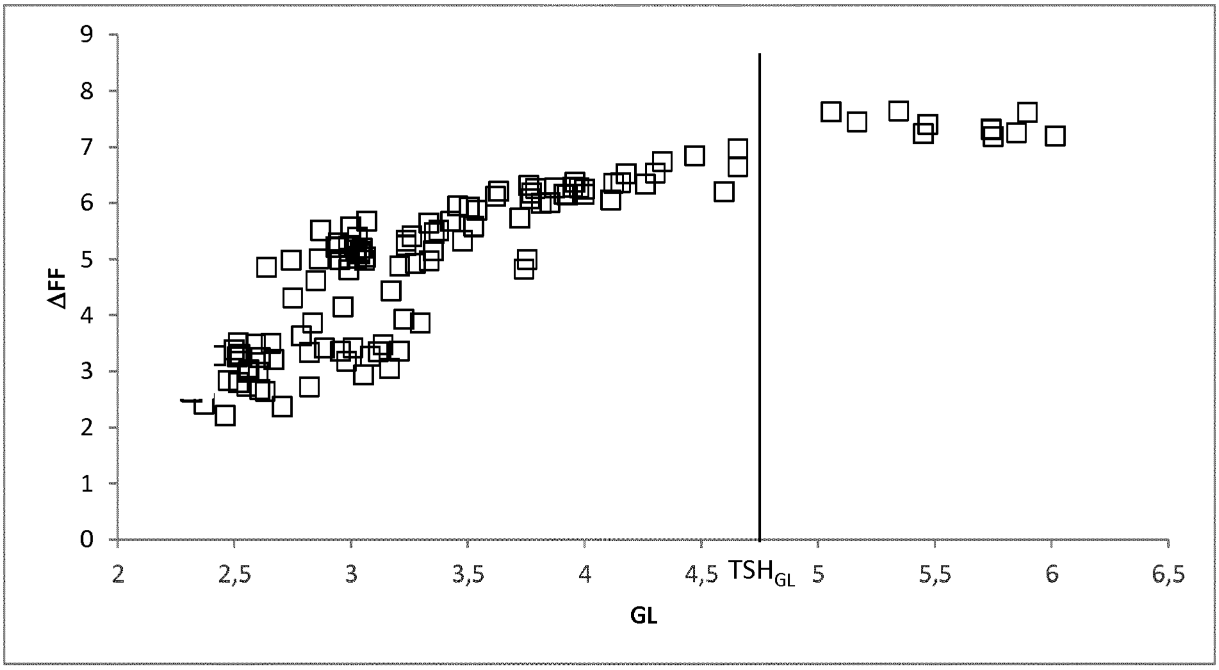


Figure 8

Europäisches Patentamt
European Patent Office
Office européen des brevets

# RAPPORT DE RECHERCHE EUROPEENNE

Numéro de la demande
EP 19 15 8799

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | B. HALLAM, T. TRUPKE, Y. AUGERTEN, B. TJAHNOHO, S. WENHAM: "Photoluminesce Imaging For Fast Determination Of the Implied Open Circuit Voltage Of Silicon Wafers", THE COMPILED STATE-OF-THE-ART OF PV SOLAR TECHNOLOGY AND DEPLOYMENT : 24TH EUROPEAN PHOTOVOLTAIC SOLAR ENERGY CONFERENCE AND EXHIBITION ; CONFERENCE 21 - 25 SEPTEMBER 2009, EXHIBITION 21 - 24 SEPTEMBER 2009, HAMBURG ; PROCEEDINGS ; EU PVSEC, WIP-RENE, 21 septembre 2009 (2009-09-21), XP040530178, ISBN: 978-3-936338-25-6 | 1-3, 11-13 | INV. G01N21/64 G01N21/95 ADD. H01L21/66 |
| Y | * page 2016, colonne de gauche; figures 1, 2; tableau 1 * | 6-10,14, 15 | |
| A | | 4,5 | |
| | ----- | | |
| Y,D | BERNHARD MICHL ET AL: "Suns-PLI as a powerful tool for spatially resolved fill factor analysis of solar cells", PROGRESS IN PHOTOVOLTAICS: RESEARCH AND APPLICATIONS, vol. 22, no. 5, 25 octobre 2012 (2012-10-25), pages 581-586, XP055133909, ISSN: 1062-7995, DOI: 10.1002/pip.2293 * partie 3.3; figure 4 * | 6-10,14, 15 | **DOMAINES TECHNIQUES RECHERCHES (IPC)** G01N H01L |
| | ----- | | |
| A | US 2012/142125 A1 (TRUPKE THORSTEN [AU] ET AL) 7 juin 2012 (2012-06-07) * alinéa [0032] * | 2,3 | |
| | ----- | | |
| | -/-- | | |

Le présent rapport a été établi pour toutes les revendications

| Lieu de la recherche | Date d'achèvement de la recherche | Examinateur |
|---|---|---|
| Munich | 11 avril 2019 | Seck, Martin |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

2

EPO FORM 1503 03.82 (P04C02)

page 1 de 2

Europäisches Patentamt
European Patent Office
Office européen des brevets

## RAPPORT DE RECHERCHE EUROPEENNE

Numéro de la demande
EP 19 15 8799

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | WO 2009/129575 A1 (BT IMAGING PTY LTD [AU]; KAMPWERTH HENNER [AU]; TRUPKE THORSTEN [AU];) 29 octobre 2009 (2009-10-29) * alinéas [0030], [0036], [0047] * ----- | 2,3,10, 13 | |
| A | R. BAKOWSKIE ET AL.: "Comparison of Recombination Active Defects in Multicrystalline Silicon by Means of Photoluminescence Imaging and Reverse Biased Electroluminescence", PROCEEDINGS / 26TH EUROPEAN PHOTOVOLTAIC SOLAR ENERGY CONFERENCE AND EXHIBITION, 5 septembre 2011 (2011-09-05), XP040637481, ISBN: 978-3-936338-27-0 * Partie 2.2 * ----- | 6,7,14, 15 | |
| A | Tiago Ferreira ET AL: "ImageJ User Guide IJ 1.46r", , 2 octobre 2012 (2012-10-02), XP055178810, Extrait de l'Internet: URL:http://rsbweb.nih.gov/ij/docs/guide/user-guide.pdf [extrait le 2015-03-24] * Parties 28.2.4, 29.11.2, 29.14 * ----- | 6,7,14, 15 | DOMAINES TECHNIQUES RECHERCHES (IPC) |

Le présent rapport a été établi pour toutes les revendications

2

| Lieu de la recherche | Date d'achèvement de la recherche | Examinateur |
|---|---|---|
| Munich | 11 avril 2019 | Seck, Martin |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.........................................................................................
& : membre de la même famille, document correspondant

EPO FORM 1503 03.82 (P04C02)

page 2 de 2

## ANNEXE AU RAPPORT DE RECHERCHE EUROPEENNE RELATIF A LA DEMANDE DE BREVET EUROPEEN NO.

EP 19 15 8799

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

11-04-2019

| Document brevet cité au rapport de recherche | Date de publication | Membre(s) de la famille de brevet(s) | Date de publication |
|---|---|---|---|
| US 2012142125 A1 | 07-06-2012 | CN 102575986 A | 11-07-2012 |
| | | TW 201125150 A | 16-07-2011 |
| | | US 2012142125 A1 | 07-06-2012 |
| | | WO 2011017775 A1 | 17-02-2011 |
| WO 2009129575 A1 | 29-10-2009 | CN 102017116 A | 13-04-2011 |
| | | WO 2009129575 A1 | 29-10-2009 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Littérature non-brevet citée dans la description


- **AUGARTEN Y. ; TRUPKE T. ; LENIO M. ; BAUER J. ; WEBER J.W. ; JUHL M. ; KASEMANN M. ; BREITENSTEIN O.** Calculation of quantitative shunt values using photoluminescence imaging. *Prog. Photovolt. : Res. Appli.,* 2013, vol. 21, 933-941
- **MCHL B. ; IMPERA D. ; BIVOUR M. ; WARTA W. ; SCHUBERT M.C.** Suns-PLI as a powerful tool for spatially resolved fill factor analysis of solar cells. *Prog. Photovolt. : Res. Appl.,* 2012
- **JOHNSTON S. et al.** Correlations of Cu(In, Ga)Se2 imaging with device performance, defects and microstructural properties. *J. Vac. Sci. Technol. A,* 2012, vol. 30
- A Fill Factor Loss Analysis Method for Silicon Wafer Solar Cells. *IEEE Journal of photovoltaics,* Octobre 2013, vol. 3 (4